# EUROPEAN PATENT SPECIFICATION

(11) **EP 3 923 342 B1**
(45) Date of publication and mention of the grant of the patent: **05.03.2025**
(21) Application number: 21178224.8
(22) Date of filing: 08.06.2021
(51) Int. Cl.: H10K 59/131, H10K 59/38, H10K 50/842

(54) **DISPLAY DEVICE**
ANZEIGEVORRICHTUNG
DISPOSITIF D'AFFICHAGE

(30) Priority: 08.06.2020 KR 20200069172
(43) Date of publication of application: 15.12.2021
(73) Proprietor: Samsung Display Co., Ltd., Yongin-si Gyeonggi-do 17113 (KR)
(72) Inventor: JUNG, Hyung Gi, Cheonan-si (KR); KIM, Ki Hwan, Anyang-si (KR); KIM, Beom Jin, Seoul (KR); YEON, Soon Chang, Seongnam-si (KR); LEE, Sung Hyun, Cheonan-si (KR); LEE, Jae Min, Asan-si (KR); LEE, Jae Young, Cheonan-si (KR); HYUN, You Mee, Seoul (KR)
(74) Representative: Marks & Clerk LLP

(56) References cited:
- CN-A- 109 920 935
- US-A1- 2019 157 605
- US-A1- 2019 348 491
- US-A1- 2020 144 351
- US-A1- 2020 152 705
- US-A1- 2020 303 485

## Description

### BACKGROUND

### 1. Field

Aspects of some example embodiments of the present disclosure relate to a display device.

### 2. Description of the Related Art

Display devices have become more important as multimedia technology has evolved. Accordingly, a variety of display devices such as liquid-crystal display devices (LCDs) and organic light-emitting diode display devices (OLEDs) may be utilized in various electronic devices.

Among display devices, a self-luminous display device includes a self-luminous element, for example, an organic light-emitting element. A self-luminous element may include two opposing electrodes and an emissive layer interposed therebetween. For an organic light-emitting element as a self-luminous element, electrons and holes supplied from the two electrodes are recombined in the emissive layer to generate excitons, the generated excitons relax from the excited state to the ground state and accordingly light can be emitted.

Such a self-luminous display device generally may not utilize a separate light source such as a backlight unit, and thus self-luminous display devices may generally consume relatively less power, may be relatively light and thin, and may have high-quality characteristics such as relatively wide viewing angles, high luminance and contrast, and relatively fast response speeds, compared to alternative display devices. Accordingly, organic light-emitting display devices are attracting attention as the next generation display device.

The above information disclosed in this Background section is only for enhancement of understanding of the background and therefore the information discussed in this Background section does not necessarily constitute prior art.

United States Patent Application Publication US 2020/152705 A1 relates to a display device including a first substrate; light-emitting elements disposed on the first substrate; an encapsulation film covering the light-emitting elements; a second substrate facing the first substrate; a first outermost film disposed on the second substrate to face the encapsulation film and including AO_{X}N_{Y} (where A is a metal or non-metal element and X>Y); and a filler material disposed between the encapsulation film and the first outermost film and placed in direct contact with the first outermost film.

United States Patent Application Publication US 2019/157605 A1 relates to a display device including: a first substrate including a first region, a third region spaced apart from and surrounding the first region, and a second region located between the first region and the third region; a second substrate opposite to the first substrate; a display element including a first electrode on the first substrate, a light emitting layer provided on the first electrode, and a second electrode provided on the light emitting layer; a touch sensing part disposed on the second substrate; and a sealing member provided on the third region of the first substrate, the sealing member joining the first substrate and the second substrate, wherein the second electrode overlaps with the touch sensing part when viewed on a plane, and an end of the second electrode is spaced apart from an end of the touch sensing part at a certain distance in the direction of the sealing member in the second region.

### SUMMARY

Aspects of some example embodiments according to the present disclosure include a display device that can prevent or reduce the introduction of static electricity into a display area.

These and other aspects and characteristics of embodiments according to the present disclosure will become more apparent to those of ordinary skill in the art upon review of the Detailed Description and Claims to follow.

According to the present invention, a display device is provided as recited in claim 1.

According to some example embodiments according to the present disclosure, it may be possible to prevent or reduce introduction of static electricity into a display area.

It should be noted that the characteristics of embodiments according to the present disclosure are not limited to those described above and other characteristics of embodiments according to the present disclosure will be more apparent to those skilled in the art from the following descriptions.

### BRIEF DESCRIPTION OF THE DRAWINGS

The above and other aspects and features of the present disclosure will become more apparent by describing in more detail aspects of some example embodiments thereof with reference to the attached drawings, in which:
FIG. 1 is a cross-sectional view for illustrating a stack structure of a display device according to some example embodiments of the present disclosure;
FIG. 2 is a plan view of a display device according to some example embodiments of the present disclosure;
FIG. 3 is an enlarged, plan view of the portion Q1 of FIG. 2, more specifically, a plan view of a display substrate included in the display device of FIG. 2 according to some example embodiments;
FIG. 4 is an enlarged plan view of the portion Q1 of FIG. 2, more specifically, a plan view of a color conversion substrate included in the display device of FIG. 2 according to some example embodiments;
FIG. 5 is a plan view of a modification of the example shown in FIG. 3 according to some example embodiments;
FIG. 6 is a plan view showing a modification of the example shown in FIG. 4 according to some example embodiments;
FIG. 7 is an enlarged plan view of the portion Q3 of FIG. 2 according to some example embodiments;
FIG. 8 is an enlarged plan view of the portion Q5 of FIG. 2;
FIG. 9 is a cross-sectional view of the display device according to some example embodiments of the present disclosure, taken along the line X3 - X3' of FIGS. 3 and 4;
FIG. 10 is an enlarged cross-sectional view of the portion Q7 of FIG. 9;
FIG. 11 is a cross-sectional view showing a modification of the structure shown in FIG. 10;
FIG. 12 is a cross-sectional view of the display device according to some example embodiments of the present disclosure, taken along the line X3 - X3 of FIG. 7;
FIG. 13 is a cross-sectional view of the display device according to some example embodiments of the present disclosure, taken along the line X5 - X5' of FIG. 8;
FIG. 14 is a plan view showing a layout of a third color filter and a color pattern on a color conversion substrate of a display device according to some example embodiments of the present disclosure;
FIG. 15 is a plan view showing a layout of a light-blocking member on the color conversion substrate of the display device according to some example embodiments of the present disclosure;
FIG. 16 is a plan view showing a layout of a first color filter on the color conversion substrate of the display device according to some example embodiments of the present disclosure;
FIG. 17 is a plan view showing a layout of a second color filter on the color conversion substrate of the display device according to some example embodiments of the present disclosure;
FIG. 18 is a plan view showing layouts of a bank pattern, a first wavelength conversion pattern, a second wavelength conversion pattern and a light-transmitting pattern in the color conversion substrate of the display device according to some example embodiments of the present disclosure;
FIG. 19 is a view showing a path in which static electricity is introduced from the outside according to some example embodiments of the present disclosure;
FIG. 20 is a cross-sectional view of a display device according to some example embodiments of the present disclosure; and
FIG. 21 is a cross-sectional view of a display device according to some example embodiments of the present disclosure.

### DETAILED DESCRIPTION

Specific structural and functional descriptions of embodiments of the invention disclosed herein are only for illustrative purposes of the embodiments of the invention. The invention may be embodied in many different forms without departing from the significant characteristics of the invention. Therefore, the embodiments of the invention are disclosed only for illustrative purposes and should not be construed as limiting the invention. That is, the invention is only defined by the scope of the claims.

It will be understood that when an element is referred to as being related to another element such as being "coupled" or "connected" to another element, it can be directly coupled or connected to the other element or intervening elements may be present therebetween. In contrast, it should be understood that when an element is referred to as being related to another element such as being "directly coupled" or "directly connected" to another element, there are no intervening elements present. Other expressions that explain the relationship between elements, such as "between," "directly between," "adjacent to," or "directly adjacent to," should be construed in the same way.

Throughout the specification, the same reference numerals will refer to the same or like parts.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The example term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The example terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Aspects of some example embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, aspects of some example embodiments of the invention will be described with reference to the attached drawings.

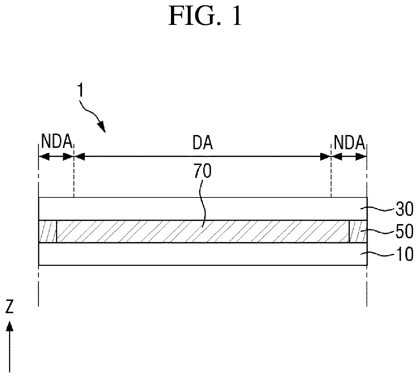

FIG. 1 is a cross-sectional view for illustrating a stack structure of a display device according to some example embodiments of the present disclosure.

A display device 1 shown in FIG. 1 may be employed in a variety of electronic devices including small-and-medium sized electronic devices such as a tablet PC, a smartphone, a vehicle navigation unit, a camera, a center information display (CID) installed in vehicles, a wrist-type electronic device (e.g., a smart watch), a personal digital assistant (PMP), a portable multimedia player (PMP) and a game machine, and medium-and-large electronic devices such as a television, an electric billboard, a monitor, a personal computer and a laptop computer. The above-listed electronic devices are merely illustrative and the display device 1 may be employed in a variety of other electronic devices without departing from the scope of embodiments according to the present disclosure.

The display device 1 may include a display area DA where images are displayed, and a non-display area NDA where no images are displayed. According to some example embodiments, the non-display area NDA may be located around (e.g., outside a footprint of, or around a periphery of) the display area DA to surround it. Images displayed on the display area DA may be seen by a user from the side indicated by the arrow in the third direction Z.

According to some example embodiments, the stack structure of the display device 1 may include a display substrate 10, and a color conversion substrate 30 opposed to the display substrate 10. The stack structure of the display device 1 may further include a sealing member 50 used to couple the display substrate 10 with the color conversion substrate 30, and a filler 70 used to fill a space or area between the display substrate 10 and the color conversion substrate 30, as shown in FIG. 1.

The display substrate 10 may include elements and circuits for displaying images, e.g., a pixel circuit such as a switching element, a pixel-defining layer for defining an emission area and a non-emission area to be described later in the display area DA, and a self-luminous element. According to some example embodiments, the self light-emitting element may include at least one of an organic light-emitting diode, a quantum-dot light-emitting diode, or an inorganic-based micro light-emitting diode (e.g., Micro LED), or an inorganic-based nano light-emitting diode having a nano size (e.g., Nano LED). In the following description, an organic light-emitting diode will be described as an example of the self-luminous element for convenience of illustration, but embodiments according to the present disclosure are not limited thereto.

The color conversion substrate 30 may be located on the display substrate 10 and may face the display substrate 10. According to some example embodiments, the color conversion substrate 30 may include a color conversion pattern that converts the color of incident light. According to the invention, the color conversion substrate 30 includes a color filter and a wavelength conversion pattern as the color conversion pattern.

The sealing member 50 may be located between the display substrate 10 and the color conversion substrate 30 in the non-display area NDA. The sealing member 50 may be arranged or formed along the edges of the display substrate 10 and the color conversion substrate 30 in the non-display area NDA to surround the display area DA when viewed from a plan view or the top (e.g., when viewing the display surface of the display device 1). The display substrate 10 and the color conversion substrate 30 may be coupled to each other via the sealing member 50.

According to some example embodiments, the sealing member 50 may be made of an organic material or any suitable sealing material for joining the color conversion substrate 30 to the display substrate 10 and for preventing or reducing instances of water, air, or other contaminants contaminating the display substrate 10 or the color conversion substrate 30. For example, the sealing member 50 may be made of, but is not limited to, an epoxy resin.

The filler 70 may be located in the space between the display substrate 10 and the color conversion substrate 30 surrounded by the sealing member 50. The filler 70 may be used to fill the space between the display substrate 10 and the color conversion substrate 30.

According to some example embodiments, the filler 70 may be made of a material that transmits light. According to some example embodiments, the filler 70 may be made of an organic material. For example, the filler 70 may be made of a silicon-based organic material, an epoxy-based organic material or a mixture of a silicon-based organic material, an epoxy-based organic material, etc.

According to some example embodiments, the filler 70 may be made of a material having an extinction coefficient of substantially zero. The refractive index and the extinction coefficient are correlated, and thus the refractive index decreases with the extinction coefficient. If the refractive index is 1.7 or less, the extinction coefficient may converge to substantially zero. According to some example embodiments, the filler 70 may be made of a material having a refractive index of 1.7 or less. Accordingly, it may be possible to prevent or reduce light provided by the self-luminous element passing through the filler 70 from being absorbed by the filler 70. According to some example embodiments, the filler 70 may be made of an organic material having a refractive index of 1.4 to 1.6.

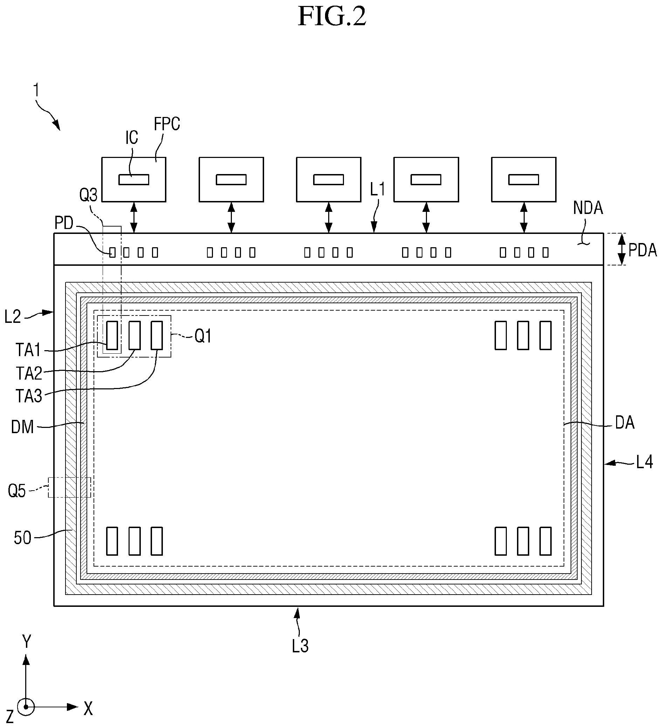

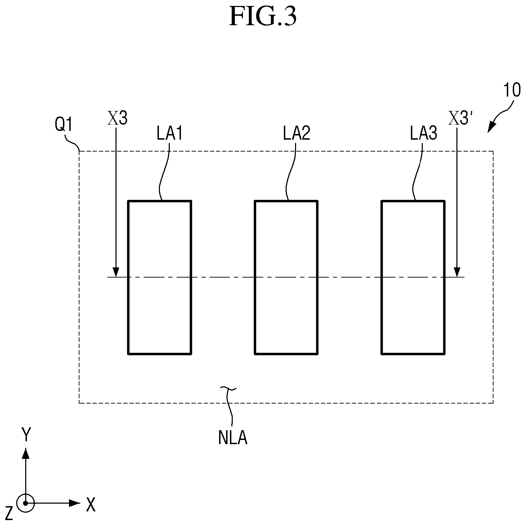

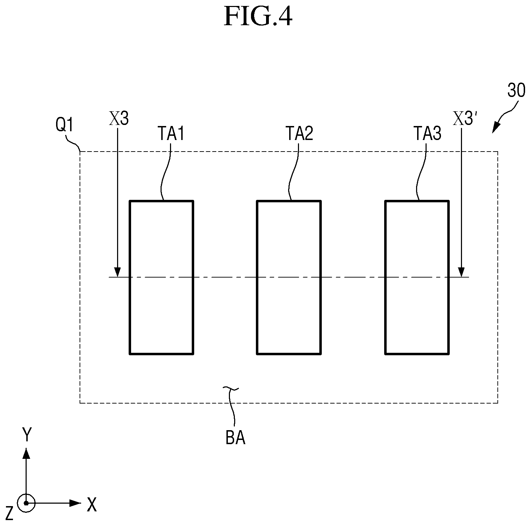

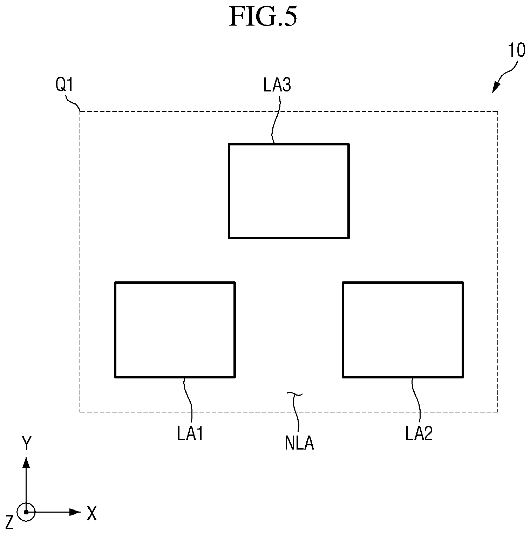

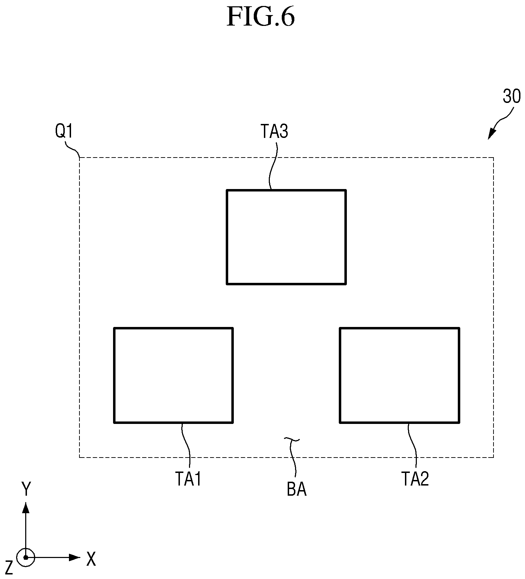

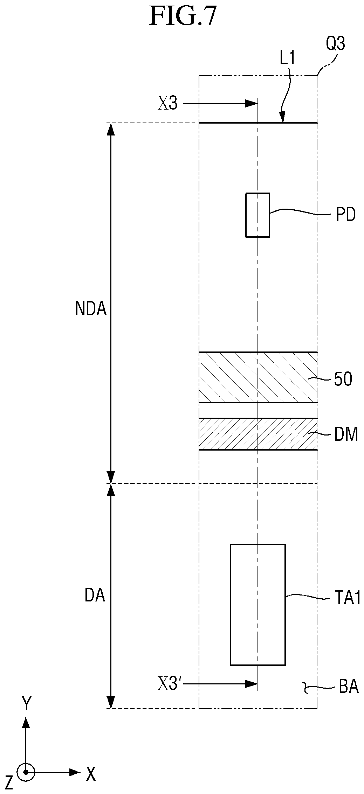

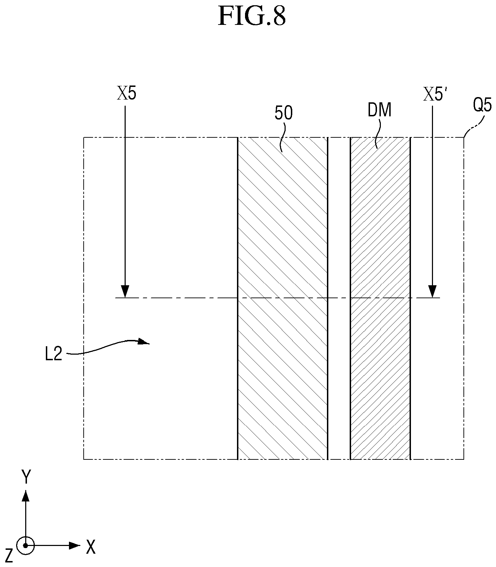

FIG. 2 is a plan view of a display device according to some example embodiments of the present disclosure. FIG. 3 is an enlarged plan view of portion Q1 of FIG. 2, more specifically, a plan view of a display substrate included in the display device of FIG. 2. FIG. 4 is an enlarged plan view of portion Q1 of FIG. 2, more specifically, a plan view of a color conversion substrate included in the display device of FIG. 2. FIG. 5 is a plan view showing a modification of the example shown in FIG. 3. FIG. 6 is a plan view showing a modification of the example shown in FIG. 4. FIG. 7 is an enlarged plan view of portion Q3 of FIG. 2. FIG. 8 is an enlarged plan view of portion Q5 of FIG. 2.

Referring to FIGS. 2 to 8 in conjunction with FIG. 1, according to some example embodiments, as shown in FIG. 2, the display device 1 may be formed in a rectangular shape when viewed from the top or a plan view (e.g., a direction normal or perpendicular to the surface). The display device 1 may include two sides extended in a first direction X, i.e., a first side L1 and a third side L3, and two sides extended in a second direction Y intersecting the first direction X, i.e., a second side L2 and a fourth side L4. Although the corners where the sides meet each other may form a right angle, the present disclosure is not limited thereto. According to some example embodiments, the length of the first side L1 and the third side L3 may be different from the length of the second side L2 and the fourth side L4. For example, the first side L1 and the third side L3 may be longer than the second side L2 and the fourth side L4. The shape of the display device 1 when viewed from the top is not limited to that shown in the drawings. The display device 1 may have a circular shape or other shapes.

According to some example embodiments, the display device 1 may further include flexible circuit boards FPC and driver chip ICs.

As shown in FIG. 3, a plurality of emission areas and a non-emission area NLA may be defined on the display substrate 10 in the display area DA.

According to some example embodiments, a first emission area LA1, a second emission area LA2 and a third emission area LA3 may be defined in the display area DA of the display substrate 10. In the emission areas LA1, LA2 and LA3, light generated in the light-emitting elements of the display substrate 10 exits out of the display substrate 10. In the non-emission area NLA, no light exit out of the display substrate 10. According to some example embodiments, the non-emission area NLA may surround the first emission area LA1, the second emission area LA2 and the third emission area LA3 inside the display area DA.

According to some example embodiments, the light exits out of the first emission area LA1, the second emission area LA2 and the third emission area LA3 may be light of a third color. According to some example embodiments, the light of the third color may be blue light and may have a peak wavelength in the range of approximately 440 to 480 nm. As used herein, the peak wavelength refers to the wavelength at which the intensity of the light is largest.

According to some example embodiments, the first emission area LA1, the second emission area LA2 and the third emission area LA3 may form a single group, window a plurality of such groups may be defined in the display area DA.

In some embodiments, as shown in FIG. 3, the first emission area LA1, the second emission area LA2 and the third emission area LA3 may be located sequentially along the first direction X. According to some example embodiments, the first emission area LA1, the second emission area LA2 and the third emission area LA3 may form a single group and may be repeatedly arranged along the first direction X and the second direction Y.

It is, however, to be understood that the present disclosure is not limited thereto. The arrangement of the first emission area LA1, the second emission area LA2 and the third emission area LA3 may be altered in a variety of ways. For example, as shown in FIG. 5, the first emission area LA1 and the second emission area LA2 may be adjacent to each other along the first direction X, while the third emission area LA3 may be located on one side of the first emission area LA1 and the second emission area LA2 along the second direction Y.

In the following description, an example will be described where the first emission area LA1, the second emission area LA2 and the third emission area LA3 are arranged as shown in FIG. 3.

As shown in FIG. 4, according to the invention a plurality of light-transmitting areas and a light-blocking area BA are defined in the color conversion substrate 30 in the display area DA. In the light-transmitting areas, the light exiting from the display substrate 10 may transmit the color conversion substrate 30 to be provided to the outside of the display device 1. In the light-blocking area BA, the light exiting from the display substrate 10 cannot pass through it.

According to some example embodiments, a first light-transmitting area TA1, a second light-transmitting area TA2 and a third light-transmitting area TA3 may be defined on the color conversion substrate 30.

The first light-transmitting area TA1 may have the size equal to the size of the first emission area LA1 or may overlap the first emission area LA1. Similarly, the second light-transmitting area TA2 may have the size equal to the size of the second emission area LA2 or may overlap the second emission area LA2, and the third light-transmitting area TA3 may have the size equal to the size of the third emission area LA3 or may overlap the third emission area LA3.

According to some example embodiments, when the first emission area LA1, the second emission area LA2 and the third emission area LA3 are arranged sequentially along the first direction X as shown in FIG. 3, the first light-transmitting area TA1, the second light-transmitting area TA2 and the third light-transmitting area TA3 may also be arranged sequentially along the first direction X as shown in FIG. 4.

Alternatively, when the first emission area LA1 and the second emission area LA2 are adjacent to each other in the first direction X while the third emission area LA3 is located on one side of the first emission area LA1 and the second emission area
LA2 in the second direction Y as shown in FIG. 5, the first light-transmitting area TA1 and the second light-transmitting area TA2 are adjacent to each other in the first direction X while the third light-transmitting area TA3 may be located on one side of the first light-transmitting area TA1 and the second light-transmitting area TA2 in the second direction Y, as shown in FIG. 6.

According to some example embodiments, the light of the third color provided from the display substrate 10 may pass through the first light-transmitting area TA1, the second light-transmitting area TA2 and the third light-transmitting area TA3 to exit out of the display device 1. In the following description, the light exiting out of the display device 1 through the first light-transmitting area TA1 is referred to as a first exiting light, the light exiting out of the display device 1 through the second light-transmitting area TA2 is referred to as second exiting light, and the light exiting out of the display device 1 through the third light-transmitting area TA3 is referred to as third exiting light. The first exiting light may be light of a first color, the second exiting light may be light of a second color different from the first color, and the third exiting light may be light of the third color. The first, second, and third exiting lights may have different colors. According to some example embodiments, the light of the third color may be blue light having a peak wavelength in the range of approximately 440 to 480 nm as described above, and the light of the first color may be red light having a peak wavelength in the range of approximately 610 to 650 nm. In addition, the light of the second color may be green light having a peak wavelength in the range of approximately 510 to 550 nm.

The light-blocking area BA may be located in the display area DA around the first light-transmitting area TA1, the second light-transmitting area TA2 and the third light-transmitting area TA3 According to some example embodiments, the light-blocking BA may surround the first light-transmitting area TA1, the second light-transmitting area TA2 and the third light-transmitting area TA3. In addition, the light-blocking area BA may be located also in the non-display area NDA of the display device 1.

Referring back to FIG. 2, a dam member DM and a sealing member 50 may be located in the non-display area NDA of the display device 1.

The dam member DM can block the overflow of an organic material (or monomers) in the process of forming the encapsulation layer located in the display area DA, thereby preventing the organic material in the encapsulation layer from extending toward the edge of the display device 1.

According to some example embodiments, the dam member DM may be formed to completely surround the display area DA when viewed from the top.

The sealing member 50 may couple the display substrate 10 with the color conversion substrate 30 as described above.

The sealing member 50 may be located in the non-display area NDA on the outer side of the dam member DM and may be formed to completely surround the dam member DM and the display area DA when viewed from the top.

The non-display area NDA of the display device 1 may include a pad area PDA, and a plurality of connection pads PD may be located in the pad area PDA.

According to some example embodiments, the connection pads PD may be located adjacent to a longer side of the non-display area NDA and may be located adjacent to the first side L1 in the non-display area NDA, for example. The connection pads PD may be electrically connected to pixel circuits and the like located in the display area DA through connection lines and the like.

According to some example embodiments, the connection pads PD may be located on the outer side of the sealing member 50. In other words, the connection pads PD may be located farther away from the display area DA than the sealing member 50 is. According to some example embodiments, the connection pads PD may be located between the sealing member 50 and the first side L1 of the display device 1.

The display substrate 10 (see, e.g., FIG. 1) of the display device 1 may include the dam member DM and the connection pads PD.

The flexible circuit boards FPC may be connected to the connection pads PD. The flexible circuit boards FPC may electrically connect the display substrate 10 (see, e.g., FIG. 1) with circuit boards that provide signals, power, etc. for driving the display device 1. For example, a constant voltage may be applied to a voltage supply line VSL, which is to be described later, through at least one of the connection pads PD. The constant voltage applied to the voltage supply line VSL may be, for example, a low-level voltage of approximately 0 V or less.

The driver chips IC may be electrically connected to the circuit boards and the like to receive data and signals. According to some example embodiments, the driver chips IC may include a data driver chip and may receive a data control signal and image data from the circuit boards to generate and output a data voltage associated with the image data.

According to some example embodiments, the driver chips IC may be mounted on the flexible circuit boards FPC, respectively. For example, the driver chips IC may be mounted on the flexible circuit boards FPC by a known chip-on-film (COF) technique.

The data voltage supplied from the driver chips IC, the supply voltage supplied from the circuit boards, etc. may be transmitted to the pixel circuit of the display substrate 10 (see, e.g., FIG. 1) through the flexible circuit boards FPC and the connection pads PD.

Hereinafter, the structure of the display device 1 will be described in more detail.

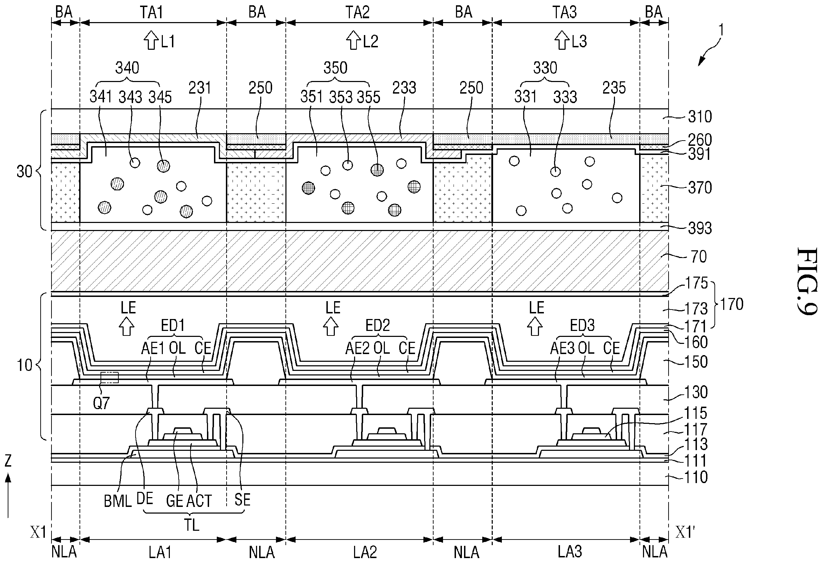

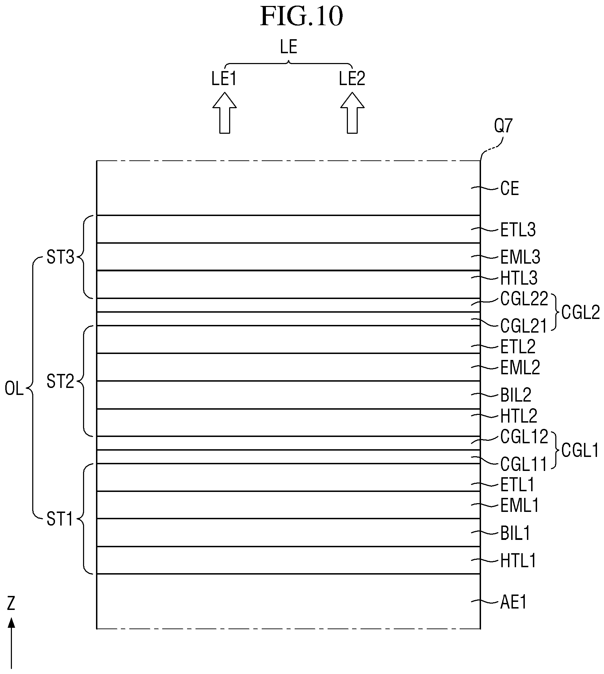

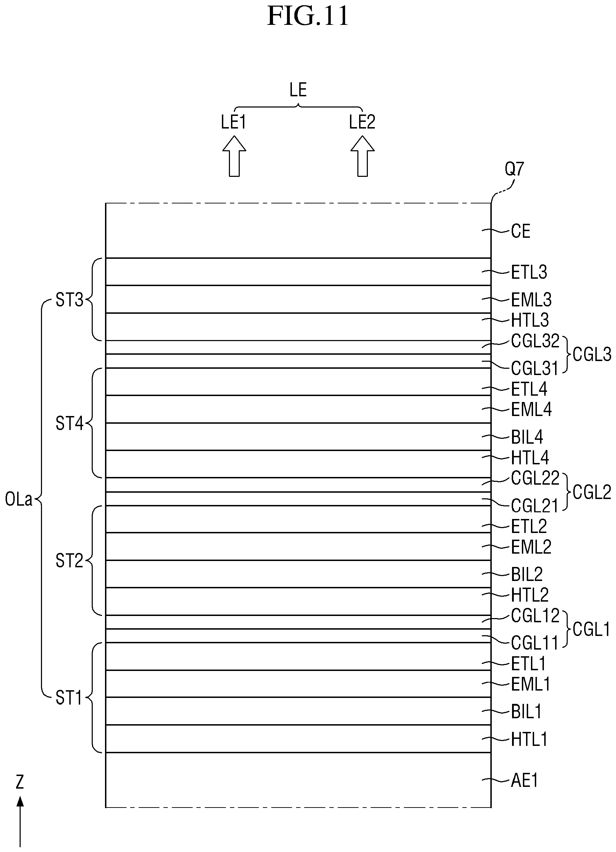

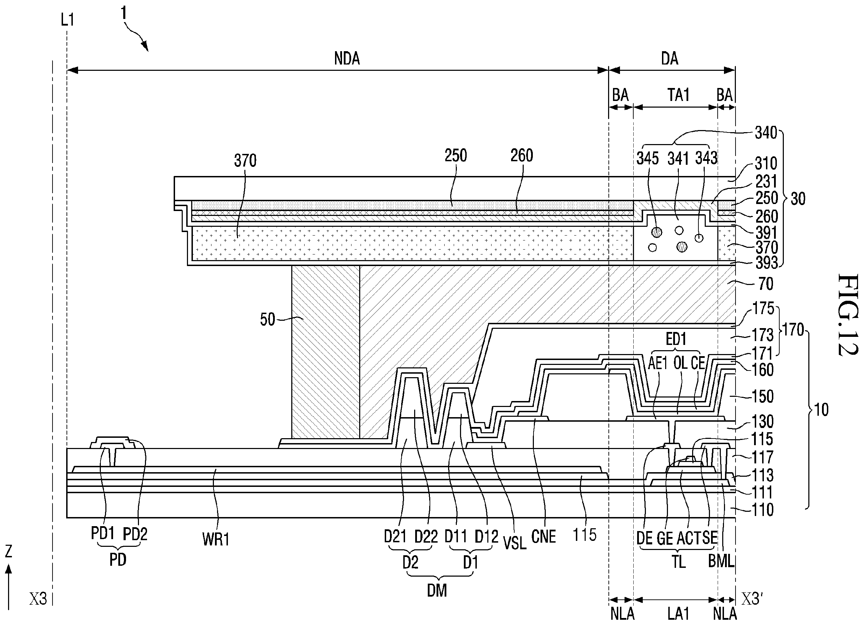

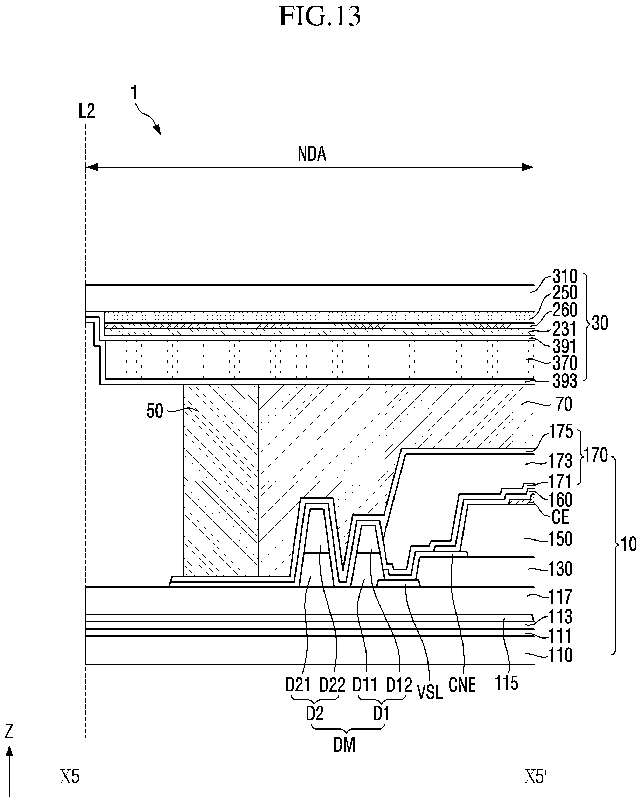

FIG. 9 is a cross-sectional view of the display device according to some example embodiments of the present disclosure, taken along line X3 - X3' of FIGS. 3 and 4. FIG. 10 is an enlarged cross-sectional view of portion Q7 of FIG. 9. FIG. 11 is a cross-sectional view showing a modification of the structure shown in FIG. 10. FIG. 12 is a cross-sectional view of the display device according to some example embodiments of the present disclosure, taken along line X3 - X3 of FIG. 7. FIG. 13 is a cross-sectional view of the display device according to some example embodiments of the present disclosure, taken along line X5 - X5' of FIG. 8.

Referring to FIGS. 9 to 13 in conjunction with FIGS. 1 to 8, the display device 1 may include the display substrate 10 and the color conversion substrate 30 as described above, and may further include the filler 70 located between the display substrate 10 and the color conversion substrate 30.

Hereinafter, the display substrate 10 will be described.

A first base 110 may be made of a light-transmitting material. According to some example embodiments, the first base 110 may be a glass substrate or a plastic substrate. When the first base 110 is a plastic substrate, the first base 110 may have flexibility.

According to some example embodiments, the plurality of emission areas LA1, LA2 and LA3 and the non-emission area NLA may be defined on the first base 110 in the display area DA, which has been described above.

According to some example embodiments, the first side L1, the second side L2, the third side L3 and the fourth side L4 of the display device 1 may be identical to the four sides of the first base 110, respectively. That is to say, the first side L1, the second side L2, the third side L3 and the fourth side L4 of the display device 1 may be referred to as the first side L1, the second side L2, the third side L3, and the fourth side L4, respectively.

A buffer layer 111 may be further located on the first base 110. The buffer layer 111 may be located on the first base 110 in the display area DA and the non-display area NDA. The buffer layer 111 can block foreign substances or moisture from permeating through the first base 110. For example, the buffer layer 111 may include an inorganic material such as SiO₂, SiNx, and SiON, and may be made up of in a single layer or multiple layers.

A light-blocking pattern BML may be located on the buffer layer 111. The light-blocking pattern BML can block external light or light from the light-emitting element from entering a semiconductor layer ACT, which will be described later, thereby preventing or reducing leakage current from being generated by light in the thin-film transistor TL, will be described later.

According to some example embodiments, the light-blocking pattern BML may be made of a material that blocks light and has conductivity. For example, the light-blocking pattern BML may include a single material of metals such as silicon (Ag), nickel (Ni), gold (Au), platinum (Pt), aluminum (Al), copper (Cu), molybdenum (Mo), titanium (Ti) and neodymium (Nd), or an alloy thereof. According to some example embodiments, the light-blocking pattern BML may be made up of a single layer or multi-layer structure. For example, when the light-blocking pattern BML is made up of a multilayer structure, the light-blocking pattern BML may be, but is not limited to, a stack structure of titanium (Ti)/copper (Cu)/indium tin oxide (ITO) or a stack structure of titanium (Ti)/copper (Cu) )/aluminum oxide (Al₂O₃).

According to some example embodiments, a plurality of light-blocking patterns BML may be located. The number of the light-blocking patterns BML may be equal to the number of the semiconductor layers ACT. The light-blocking patterns BML may overlap the semiconductor layers ACT, respectively. According to some example embodiments, the width of the light-blocking patterns BML may be larger than that of the semiconductor layers ACT.

According to some example embodiments, the light-blocking pattern BML may be a part of a data line, a voltage supply line, a line that electrically connects a thin film transistor with the thin film transistor TL shown in the drawing, etc. According to some example embodiments, the light-blocking pattern BML may be made of a material having a lower resistance than the second conductive layer or the source electrode SE and the drain electrode DE included in the second conductive layer.

A first insulating layer 113 may be located on the light-blocking pattern BML. According to some example embodiments, the first insulating layer 113 may be located in the display area DA and the non-display area NDA. The first insulating layer 113 may cover the light-blocking pattern BML. According to some example embodiments, the first insulating layer 113 may include an inorganic material such as SiO₂, SiNx, SiON, Al₂O₃, TiO₂, Ta₂O, HfO₂ and ZrO₂.

The semiconductor layers ACT may be located on the first insulating layer 113. According to some example embodiments, the semiconductor layers ACT may be located in the first emission area LA1, the second emission area LA2 and the third emission area LA3 in the display area DA, respectively.

According to some example embodiments, the semiconductor layer ACT may include oxide semiconductor. For example, the semiconductor layer ACT may be made of Zn oxide, In-Zn oxide, Ga-In-Zn oxide, etc., as Zn oxide-based material, and may be an IGZO (In-Ga-Zn-O) semiconductor containing a metal such as indium (In) and gallium (Ga) in ZnO. It is, however, to be understood that the present disclosure is not limited thereto. The semiconductor layers ACT may include amorphous silicon or polysilicon.

According to some example embodiments, the semiconductor layers ACT may be arranged to overlap the light-blocking patterns BML, respectively, thereby suppressing generation of photocurrent in the semiconductor layers ACT.

A first conductive layer may be located on the semiconductor layers ACT and may include a gate electrode GE and a first gate metal WR1. The gate electrode GE may be located in the display area DA to overlap the respective semiconductor layer ACT. As shown in FIG. 12, the first gate metal WR1 may include a part of the line that electrically connects the connection pad PD (see, e.g., FIG. 2) with the elements located in the display area DA (see, e.g., FIG. 2), e.g., the thin-film transistor TL and the light-emitting element, etc.

The gate electrode GE and the first gate metal WR1 may include at least one of the materials including aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W) or copper (Cu), and may be made up of a single layer or multiple layers, taking into account adhesion to adjacent layers, surface flatness for a layer to be laminated thereon, workability, etc.

In the display area DA, a gate insulating layer 115 may be located between the semiconductor layer ACT and the first conductive layer or between the semiconductor layer ACT and the gate electrode GE. According to some example embodiments, the gate electrode GE and the gate insulating layer 115 may work as a mask for masking a channel region of the semiconductor layer ACT, and the width of the gate electrode GE and the width of the gate insulating layer 115 may be smaller than the width of the semiconductor layer ACT.

According to some example embodiments, the gate insulating layer 115 may not be made up of a single layer formed on the entire surface of the first base 110 but may be formed in a partially patterned shape. According to some example embodiments, the width of the patterned gate insulating layer 115 may be larger than the width of the gate electrode GE or the first conductive layer.

According to some example embodiments, the gate insulating layer 115 may include an inorganic material. For example, the gate insulating layer 115 may include the inorganic materials listed above as the materials of the first insulating layer 113.

In the non-display area NDA, the gate insulating layer 115 may be located on the first gate metal WR1.

A second insulating layer 117 covering the semiconductor layer ACT and the gate electrode GE may be formed over the gate insulating layer 115. The second insulating layer 117 may be located in the display area DA and the non-display area NDA. According to some example embodiments, the second insulating layer 117 may work as a planarization layer that provides a flat surface.

According to some example embodiments, the second insulating layer 117 may include an organic material. For example, the second insulating layer 117 may include, but is not limited to, at least one of: photo acryl (PAC), polystyrene, polymethyl methacrylate (PMMA), polyacrylonitrile (PAN), polyamide, polyimide, polyarylether, heterocyclic polymer, parylene, fluorine polymer, epoxy resin, benzocyclobutene series resin, siloxane series resin, or silane resin.

The second conductive layer may be formed on the second insulating layer 117, and the second conductive layer may include the source electrode SE, the drain electrode DE, the voltage supply line VSL, and a first pad electrode PD1 of the connection pads PD.

The source electrode SE and the drain electrode DE may be located in the display area DA and may be spaced apart from each other.

The drain electrode DE and the source electrode SE may be connected to the semiconductor layer ACT through the second insulating layer 117.

According to some example embodiments, the source electrode SE may pass through the first insulating layer 113 and the second insulating layer 117 and may be connected to the light-blocking pattern BML. If the light-blocking pattern BML is a part of a line that transmits a signal or a voltage, the source electrode SE may be connected to and electrically coupled with the light-blocking pattern BML and may receive the voltage applied to the line. Alternatively, if the light-blocking pattern BML is a floating pattern rather than a separate line, a voltage applied to the source electrode SE and the like may be transmitted to the light-blocking pattern BML.

Alternatively, unlike the example shown in FIG. 9, the drain electrode DE may pass through the first insulating layer 113 and the second insulating layer 117 and may be connected to the light-blocking pattern BML. If the light-blocking pattern BML is not a line receiving a separate signal, a voltage applied to the drain electrode DE and the like may be transmitted to the light-blocking pattern BML.

The semiconductor layer ACT, the gate electrode GE, the source electrode SE and the drain electrode DE may form the thin-film transistor TL that is a switching element. According to some example embodiments, the thin-film transistor TL may be located in each of the first emission area LA1, the second emission area LA2 and the third emission area LA3. According to some example embodiments, a part of the thin-film transistor TL may be located in the non-emission area NLA.

The voltage supply line VSL may be located in the non-display area NDA. A supply voltage applied to a cathode electrode CE, for example, a voltage ELVSS may be supplied to the voltage supply line VSL.

The first pad electrode PD1 of the connection pads PD may be located in the pad area PDA (see, e.g., FIG. 2) of the non-display area NDA. According to some example embodiments, the first pad electrode PD1 may pass through the second insulating layer 117 and may be electrically connected to the first gate metal WR1.

The source electrode SE, the drain electrode DE, the voltage supply line VSL and the first pad electrode PD1 of the connection pad PD may include aluminum (Al), copper (Cu), titanium (Ti), etc., and may be made up of multiple laser or a single layer. According to some example embodiments of the present disclosure, the source electrode SE, the drain electrode DE, the voltage supply line VSL and the first pad electrode PD1 of the connection pad PD may be made up of a multilayer structure of Ti/Al/Ti.

A third insulating layer 130 may be located on the second insulating layer 117. The third insulating layer 130 may cover the thin-film transistor TL in the display area DA and may expose a part of the voltage supply line VSL in the non-display area NDA.

According to some example embodiments, the third insulating layer 130 may be a planarization layer. According to some example embodiments, the third insulating layer 130 may be made of an organic material. For example, the third insulating layer 130 may include an acrylic resin, an epoxy resin, an imide resin, an ester resin, etc. According to some example embodiments, the third insulating layer 130 may include a photosensitive organic material.

A first anode electrode AE1, a second anode electrode AE2 and a third anode electrode AE3 may be located on the third insulating layer 130 in the display area DA. In addition, a connection electrode CNE and a second pad electrode PD2 of the connection pad PD may be located on the third insulating layer 130 in the non-display area NDA.

The first anode electrode AE1 may overlap the first emission area LA1 and may be at least partially extended to the non-emission area NLA. The second anode electrode AE2 may overlap the second emission area LA2 and may be at least partially extended to the non-emission area NLA, and the third anode electrode AE3 may overlap the third emission area LA3 and may be at least partially extended to the non-emission area NLA. The first anode electrode AE1 may pass through the third insulating layer 130 and may be connected to the drain electrode DE of the thin-film transistor TL associated with the first anode electrode AE1. The second anode electrode AE2 may pass through the third insulating layer 130 and may be connected to the drain electrode DE of the thin-film transistor TL associated with the second anode electrode AE2. The third anode electrode AE3 may pass through the third insulating layer 130 and may be connected to the drain electrode DE of the thin-film transistor TL associated with the third anode electrode AE3.

According to some example embodiments, the first anode electrode AE1, the second anode electrode AE2 and the third anode electrode AE3 may be reflective electrodes. In such case, the first anode electrode AE1, the second anode electrode AE2 and the third anode electrode AE3 may be metal layers containing a metal such as Ag, Mg, Al, Pt, Pd, Au, Ni, Nd, Ir and Cr. According to some example embodiments, the first anode electrode AE1, the second anode electrode AE2 and the third anode electrode AE3 may further include a metal oxide layer stacked on the metal layer. According to some example embodiments, the first anode electrode AE1, the second anode electrode AE2 and the third anode electrode AE3 may have a multilayer structure, e.g., a two-layer structure of ITO/Ag, Ag/ITO, ITO/Mg and ITO/MgF, or a three-layer structure of ITO/Ag/ITO.

The connection electrode CNE may be electrically connected to the voltage supply line VSL in the non-display area NDA and may be in direct contact with the voltage supply line VSL.

The second pad electrode PD2 may be located on the first pad electrode PD1 in the non-display area NDA. The second pad electrode PD2 may be in direct contact with and electrically connected to the first pad electrode PD1.

According to some example embodiments, the connection electrode CNE and the second pad electrode PD2 may be made of the same material as the first anode electrode AE1, the second anode electrode AE2 and the third anode electrode AE3, and may be formed together with the first anode electrode AE1, the second anode electrode AE2 and the third anode electrode AE3 via the same fabricating process.

A pixel-defining layer 150 may be located on the first anode electrode AE1, the second anode electrode AE2, and the third anode electrode AE3. The pixel-defining layer 150 may include an opening for exposing the first anode electrode AE1, an opening for exposing the second anode electrode AE2, and an opening for exposing the third anode electrode AE3 and may define the light-emitting region LA1, the second light-emitting region LA2, the third light-emitting region LA3, and the non-light-emitting region NLA. That is to say, an exposed part of the first anode electrode AE1 which is not covered by the pixel-defining layer 150 may be the first light-emitting area LA1. Similarly, an exposed part of the second anode electrode AE2 which is not covered by the pixel-defining layer 150 may be the second light-emitting area LA2. An exposed part of the third anode electrode AE3 which is not covered by the pixel-defining layer 150 may be the third light-emitting area LA3. The pixel-defining layer 150 may be located in the non-emission area NLA.

According to some example embodiments, the pixel-defining layer 150 may include an organic insulating material such as polyacrylate resin, epoxy resin, phenolic resin, polyamide resin, polyimide resin, unsaturated polyesters resin, poly phenylen ether resin, poly phenylene sulfide resin, and benzocyclobutene (BCB).

According to some example embodiments, the pixel-defining layer 150 may overlap a color pattern 250 and light-blocking pattern 260 to be described later.

In addition, according to some example embodiments, the pixel-defining layer 150 may overlap a bank pattern 370 to be described later.

As shown in FIGS. 9 and 12, an emissive layer OL may be located on the first anode electrode AE1, the second anode electrode AE2, and the third anode electrode AE3.

According to some example embodiments, the emissive layer OL may have the shape of a continuous film formed across the plurality of emission areas LA1, LA2 and LA3 and the non-emission area NLA. Although the organic emissive layer OL is located only in the display area DA in the drawings, embodiments according to the present disclosure are not limited thereto. According to some example embodiments, a part of the emissive layer OL may be further located in the non-display area NDA. The emissive layer OL will be described in more detail later.

The cathode electrode CE may be located on the emissive layer OL. A part of the cathode electrode CE may be further located in the non-display area NDA, as shown in FIG. 12. The cathode electrode CE may be electrically connected to and in contact with the connection electrode CNE in the non-display area NDA. The supply voltage, e.g., the voltage ELVSS applied to the voltage supply line VSL may be transmitted to the cathode electrode CE via the connection electrode CNE. It is to be noted that the cathode electrode CE is in contact with the connection electrode CNE in the part of the non-display area NDA that is adjacent to the first side L1 of the display device 1 as shown in FIG. 12. However, the cathode electrode is not in contact with the connection electrode CNE in the part of the non-display area NDA that is adjacent to at least one of the second side L2 to the fourth side L4 of the display device 1 excluding the first side L1 as shown in FIG. 13.

For example, at the part of the non-display area NDA that is adjacent to at least one of the second to fourth sides L2 to L4 of the display device 1 except for the first side L1, the cathode electrode CE may not be connected to the connection electrode CNE as shown in FIG. 13. At the part of the non-display area NDA that is adjacent to at least one of the second to fourth sides L2 to L4 of the display device 1 except for the first side L1, the end of the cathode electrode CE may be located on the pixel-defining layer 150. At the part of the non-display area NDA that is adjacent to at least one of the second to fourth sides L2 to L4 of the display device 1 except for the first side L1, the end of the cathode electrode CE may overlap the pixel-defining layer 150 and may be located more to the inside than the end of the pixel-defining layer 150 that faces the sealing member 50.

It is to be noted that at the part of the non-display area NDA that is adjacent to at least one of the second to fourth sides L2 to L4 of the display device 1 except for the first side L1, the end of the cathode electrode CE may be located on the side surface of the pixel-defining layer 150 that faces the sealing member 50, also in which case the cathode electrode CE may not be connected to the connection electrode CNE.

In the display device 1 in which the display substrate 10 and the color conversion substrate 30 are attached by using the sealing member 50 according to some example embodiments of the present disclosure, the static electricity generated outside the display device 1 may be introduced into the color conversion substrate 30 to affect a number of pixel circuits arranged in the display area DA of the display substrate 10.

For example, the static electricity introduced through the color conversion substrate 30 is typically negatively charged. Such negatively charged static electricity may decrease the voltage at the source electrode connected to the light-emitting element of the thin-film transistor TL (e.g., driving transistor) of the pixel circuit in the display area DA. If the voltage at the source electrode connected to the light-emitting element of the thin-film transistor TL (e.g., the driving transistor) decreases, unexpected leakage current may occur in the driving transistor, which may result in dark spots on the screen.

In order to prevent the static electricity introduced through the color conversion substrate 30 from flowing into the display area DA, a guide ring may be utilized as a path for the introduced static electricity at the overlapping portion with the sealing member 50 or on the outer side of the sealing member 50 (e.g., the area between the sealing member 50 and the sides L1 to L4 of the display device 1). Such a guide ring may be formed by employing double lines (low resistance) using the first conductive layer and the second conductive layer of the display substrate 10 described above. Unfortunately, the second conductive layer of the guide ring may be corroded. In order to prevent corrosion of the second conductive layer of the guide ring, it may be contemplated to form the guide ring using only the first conductive layer. However, if the guide ring is formed using only the first conductive layer, the resistance of the path from the color conversion substrate 30 to the guide ring may increase due to the second insulating layer 117 and the third insulating layer 130 between the guide ring and the color conversion substrate 30. As a result, the amount of the static electricity flowing into the display area DA may even increase.

Furthermore, when the guide ring which works as the path for the introduced static electricity is located on the outer side of the sealing member 50 (e.g., between the sealing member 50 and the sides L1 to L4 of the display device 1), the area of the non-display area NDA may be increased, and accordingly the dead space of the display device 1 may be increased.

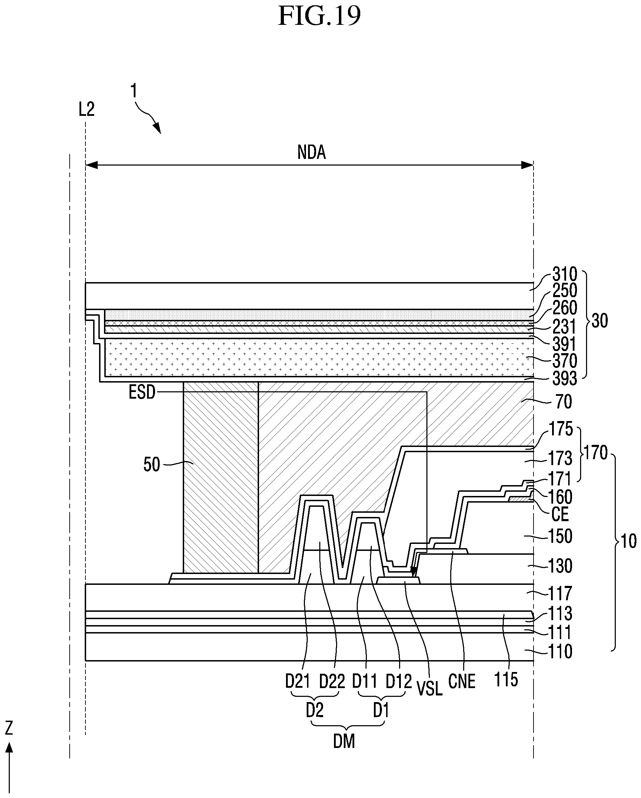

FIG. 19 is a view showing a path in which static electricity is introduced from the outside according to some example embodiments of the present disclosure.

Referring to FIG. 19, for the display device 1 according to some example embodiments of the present disclosure, a discharge path of the static electricity ESD introduced into the color conversion substrate 30 may be formed between the sealing member 50 and the display area DA. As described above, the discharge passage of the static electricity ESD introduced into the color conversion substrate 30 may be located at the part of the non-display area NDA that is adjacent to at least one of the second to fourth sides L2 to L4 of the display device 1 except for the first side L1, and may be the connection electrode CNE and the voltage supply line VSL electrically separated from the cathode electrode CE. The discharge path of the static electricity ESD is a sink pattern. The sink pattern is electrically separated from the light-emitting element.

As the discharge passage of the static electricity ESD introduced into the color conversion substrate 30, by utilizing the connection electrode CNE and the voltage supply line VSL, which are located at the part of the non-display area NDA that is adjacent to at least one of the second to fourth sides L2 to L4 of the display device 1 except for the first side L1 and electrically separated from the cathode electrode CE, the area of the non-display area NDA can be increased. As a result, it may be possible to reduce the dead space of the display device 1. More specifically, a dead space in the display area DA of the display device 1 is reduced.

Furthermore, by utilizing the connection electrode CNE located on the same layer as the anode electrodes AE1 to AE3 as the discharge path, the resistance from the color conversion substrate 30 to the discharge path is reduced, compared to the guide ring including only the first conductive layer. As a result, it may be possible to greatly reduce the amount of static electricity flowing into the display area DA.

Referring to back to FIGS. 9 to 13, according to some example embodiments, the cathode electrode CE may be semi-transmissive or transmissive. If the cathode electrode CE is transflective, it may include Ag, Mg, Cu, Al, Pt, Pd, Au, Ni, Nd, Ir, Cr, Li, Ca, LiF/Ca, LiF/Al, Mo, Time or a compound or a mixture thereof, e.g., a mixture of Ag and Mg. Further, if the thickness of the cathode electrode CE ranges from several tens to several hundred angstroms, the cathode electrode CE may be transflective.

When the cathode electrode CE is transmissive, the cathode electrode CE may include a transparent conductive oxide (TCO). For example, the cathode electrode CE may be formed of tungsten oxide (WxOx), titanium oxide (TiO₂), indium tin oxide (ITO), indium zinc oxide (IZO), zinc oxide (ZnO), indium tin zinc oxide MgO (magnesium oxide), etc.

According to some example embodiments, the cathode electrode CE may completely cover the emissive layer OL. According to some example embodiments, as shown in FIG. 12, the end of the cathode electrode CE may be located more to the outside than the end of the emissive layer OL, and the end of the emissive layer OL may be completely covered by the cathode electrode CE.

The first anode electrode AE1, the emissive layer OL and the cathode electrode CE may form a first light-emitting diode ED1, the second anode electrode AE2, the emissive layer OL and the cathode electrode CE may form a second light-emitting diode ED2, and the third anode electrode AE3, the emissive layer OL and the cathode electrode CE may form a third light-emitting diode ED3. Each of the first light-emitting diode ED1, the second light-emitting diode ED2 and the third light-emitting diode ED3 may emit exiting light LE.

As shown in FIG. 10, the exiting light LE finally emitted from the emissive layer OL may be a mixed light form a first component LE1 and a second component LE2. Each of the first component LE1 and the second component LE2 of the exiting light LE may have a peak wavelength that is equal to or greater than 440 nm and less than 480 nm. That is to say, the exiting light LE may be blue light.

As shown in FIG. 10, according to some example embodiments, the emissive layer OL may have a structure in which a plurality of emissive layers overlaps one another, e.g., a tandem structure. For example, the emissive layer OL may include a first stack ST1 including the first emissive layer EML1, a second stack ST2 located on the first stack ST1 and including the second emissive layer EML2, a third stack ST3 located on the second stack ST2 and including the third emissive layer EML3, a first charge generation layer CGL1 located between the first stack ST1 and the second stack ST2, and a second charge generation layer CGL2 located between the second stack ST2 and the third stack ST3. The first stack ST1, the second stack ST2 and the third stack ST3 may overlap one another.

The first emission material layer EML1, the second emission material layer EML2 and the third emission material layer EML3 may overlap one another.

According to some example embodiments, the first emission material layer EML1, the second emission material layer EML2 and the third emission material layer EML3 may all emit light of the first color, e.g., blue light. For example, each of the first emission material layer EML1, the second emission material layer EML2 and the third emission material layer EML3 may be a blue emissive layer and may include an organic material.

According to some example embodiments, at least one of the first emission material layer EML1, the second emission material layer EML2, or the third emission material layer EML3 may emit first blue light having a first peak wavelength, and at least another one of the first emission material layer EML1, the second emission material layer EML2 and the third emission material layer EML3 may emit second blue light having a second peak wavelength different from the first peak wavelength. For example, one of the first emission material layer EML1, the second emission material layer EML2 and the third emission material layer EML3 may emit the first blue light having the first peak wavelength, and the other two of the first emission material layer EML1, the second emission material layer EML2 and the third emission material layer EML3 may emit the second blue light having the second peak wavelength. For example, the exiting light LE finally emitted from the emissive layer OL may be mixed light of the first component LE1 and the second component LE2, and the first component LE1 may be the first blue light having the first peak wavelength, and the second component LE2 may be the second blue light having the second peak wavelength.

According to some example embodiments, the range of one of the first peak wavelength and the second peak wavelength may be equal to or greater than 440 nm and less than 460 nm, and the range of the other of the first peak wavelength and the second peak wavelength may be equal to or greater than 460 nm and less than 480 nm. H It is, however, to be understood that the range of the first peak wavelength and the range of the second peak wavelength are not limited thereto. For example, the range of the first peak wavelength and the range of the second peak wavelength may both include 460 nm. According to some example embodiments, one of the first blue light and the second blue light may be light of deep blue color, while the other of the first blue light and the second blue light may be light of sky blue color.

According to some example embodiments, the exiting light LE emitted from the emissive layer OL is blue light and may include a long-wavelength component and a short-wavelength component. Therefore, finally, the emissive layer OL may emit blue light having an emission peak broadly distributed as the exiting light LE. In this manner, the color visibility may be improved at side viewing angles compared to alternative light-emitting elements that emit blue light having a sharp emission peak.

According to some example embodiments, each of the first emission material layer EML1, the second emission material layer EML2 and the third emission material layer EML3 may include host and dopant. The material of the host is not particularly limited herein as long as it is typically used and may include Alq3(tris(8-hydroxyquinolino)aluminum), CBP(4,4'-bis(N-carbazolyl)-1,1'-biphenyl), PVK(poly(n-vinylcabazole)), ADN(9,10-di(naphthalene-2-yl)anthracene), TCTA(4,4',4"-Tris(carbazol-9-yl)-triphenylamine), TPBi(1,3,5-tris(N-phenylbenzimidazole-2-yl)benzene), TBADN(3-tert-butyl-9,10-di(naphth-2-yl)anthracene), DSA(distyrylarylene), CDBP(4,4'-bis(9-carbazolyl)-2,2"-dimethyl-biphenyl), MADN(2-Methyl-9,10-bis(naphthalen-2-yl)anthracene), etc.

Each of the first emission material layer EML1, the second emission material layer EML2 and the third emission material layer EML3 that emits blue light may include a fluorescent material including one selected from the group consisting of: spiro-DPVBi, spiro-6P, DSB(distyryl-benzene), DSA(distyryl-arylene), PFO(polyfluorene) polymer and PPV (poly(p-phenylene vinylene) polymer. As another example, each of the first emission material layer EML1, the second emission material layer EML2 and the third emission material layer EML3 may include a phosphorescent material including an organometallic complex such as (4,6-F2ppy)2Irpic.

As described above, at least one of the first emission layer EML1, the second emission layer EML2, or the third emission layer EML3 may emit blue light in a different wavelength band from that of at least another one of them. In order to emit blue light in different wavelength ranges, the first emission layer EML1, the second emission layer EML2 and the third emission layer EML3 may include the same material and the resonance distance may be adjusted. Alternatively, in order to emit blue light in different wavelength ranges, at least one of the first emission layer EML1, the second emission layer EML2, or the third emission layer EML3 and/or at least another one of them may include different materials.

It is, however, to be understood that the present disclosure is not limited thereto. The blue light emitted by each of the first emission layer EML1, the second emission layer EML2 and the third emission layer EML3 all may have a peak wavelength of 440 nm to 480 nm, and may be made of the same material.

Alternatively, according to some example embodiments, at least one of the first emission layer EML1, the second emission layer EML2, or the third emission layer EML3 may emit the first blue light having the first peak wavelength, another one of the first emission layer EML1, the second emission layer EML2 and the third emission layer EML3 may emit the second blue light having the second peak wavelength different from the first peak wavelength, and the other one of the first emission layer EML1, the second emission layer EML2 and the third emission layer EML3 may emit third blue light having a third peak wavelength different from the first peak wavelength and the second peak wavelength. According to some example embodiments, the range of one of the first peak wavelength, the second peak wavelength and the third peak wavelength may be equal to or greater than 440 nm and less than 460 nm. The range of another one of the first peak wavelength, the second peak wavelength and the third peak wavelength may be equal to or greater than 460 nm and less than 470 nm. The range of the other one of the first peak wavelength, the second peak wavelength and the third peak wavelength may be equal to or greater than 470 nm and less than 480 nm.

According to some example embodiments, the exiting light LE emitted from the emissive layer OL is blue light and may include a long-wavelength component, a medium-wavelength component, and a short-wavelength component. Therefore, finally, the emissive layer OL may emit blue light having an emission peak broadly distributed as the exiting light LE, and the color visibility at the side viewing angles can be improved.

In the display devices according to some example embodiments, in contrast to light-emitting elements that do not employ the tandem structure, because of the structure in which a number of light-emitting elements may be stacked on one another, the luminous efficiency may be relatively increased and the lifetime of the display device may also be relatively improved.

Alternatively, according to some example embodiments, at least one of the first emission layer EML1, the second emission layer EML2, or the third emission layer EML3 may emit light of the third color, e.g., blue light, and at least another one of the first emission layer EML1, the second emission layer EML2 and the third emission layer EML3 may emit light of the third color, e.g., green light. In some other embodiments, the range of peak wavelength of blue light emitted by at least one of the first emission layer EML1, the second emission layer EML2, or the third emission layer EML3 may be from 440 nm to 480 nm, or from 460 nm to 480 nm. The green light emitted by at least another one of the first emission material layer EML1, the second emission material layer EML2 and the third emission material layer EML3 may have a peak wavelength in the range of 510 nm to 550 nm.

For example, one of the first emission material layer EML1, the second emission material layer EML2 and the third emission material layer EML3 may be a green emissive layer emitting green light, while the other two of the first emission material layer EML1, the second emission material layer EML2 and the third emission material layer EML3 may be blue emissive layers emitting blue light. When the other two of the first emission material layer EML1, the second emission material layer EML2 and the third emission material layer EML3 are blue emission material layers, the range of the peak wavelength of the blue light emitted by the two blue emission material layers may be equal to each other or different from each other.

According to some example embodiments, the exiting light LE emitted from the emissive layer OL may be a mixed light of the first component LE1 which is blue light and the second component LE2 that is green light. For example, when the first component LE1 is deep blue light and the second component LE2 is green light, the exiting light LE may be light having a sky blue color. According to some example embodiments, the exiting light LE emitted from the emissive layer OL is a mixed light of blue light and green light, and includes a long-wavelength component and a short-wavelength component. Therefore, finally, the emissive layer OL may emit blue light having an emission peak broadly distributed as the exiting light LE, and the color visibility at the side viewing angles can be improved. In addition, because the second component LE2 of the exiting light LE is green light, green light component of the light provided from the display device 1 to the outside can be supplemented, and accordingly the color gamut of the display device 1 can be improved.

According to some example embodiments, the green emissive layer of the first emission material layer EML1, the second emission material layer EML2 and the third emission material layer EML3 may include host and dopant. The material of the host included in the green emission material layer is not particularly limited herein as long as it is typically used and may include Alq3(tris(8-hydroxyquinolino)aluminum), CBP(4,4'-bis(N-carbazolyl)-1,1'-biphenyl), PVK(poly(n-vinylcabazole)), ADN(9,10-di(naphthalene-2-yl)anthracene), TCTA(4,4',4"-Tris(carbazol-9-yl)-triphenylamine), TPBi(1,3,5-tris(N-phenylbenzimidazole-2-yl)benzene), TBADN(3-tert-butyl-9,10-di(naphth-2-yl)anthracene), DSA(distyrylarylene), CDBP(4,4'-bis(9-carbazolyl)-2,2"-dimethyl-biphenyl), MADN(2-Methyl-9,10-bis(naphthalen-2-yl)anthracene), etc.

The dopant included in the green emission material layer may include, for example, a fluorescent material such as Alq3(tris-(8-hydroyquinolato) aluminum(III)), or a phosphorescent material such as Ir(ppy)3(fac tris(2-phenylpyridine)iridium), Ir(ppy)2(acac)(Bis(2-phenylpyridine)(acetylacetonate)iridium(III)) and Ir(mpyp)3(2-phenyl-4-methyl-pyridine iridium).

The first charge generation layer CGL1 may be located between the first stack ST1 and the second stack ST2. The first charge generation layer CGL1 may serve to inject charges into each of the emission material layers. The first charge generation layer CGL1 may control charge balance between the first stack ST1 and the second stack ST2. The first charge generation layer CGL1 may include an n-type charge generation layer CGL11 and a p-type charge generation layer CGL12. The p-type charge generation layer CGL12 may be located on the n-type charge generation layer CGL11 and may be 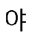 between the n-type charge generation layer CGL11 and the second stack ST2.

The first charge generation layer CGL1 may have a junction structure in which the n-type charge generation layer CGL11 and the p-type charge generation layer CGL12 are bonded with each other. The n-type charge generation layer CGL11 is located closer to the anode electrodes AE1, AE2 and AE3 than to the cathode electrode CE (see, e.g., FIG. 9). The p-type charge generation layer CGL12 is located closer to the cathode electrode CE than to the anode electrode AE1, AE2 and AE3 (see, e.g., FIG. 9). The n-type charge generation layer CGL11 supplies electrons to the first emission material layer EML1 adjacent to the anode electrodes AE1, AE2 and AE3 (see, e.g., FIG. 7), and the p-type charge generation layer CGL12 supplies holes to the second emission material layer EML2 included in the second stack ST2. By located the first charge generation layer CGL1 between the first stack ST1 and the second stack ST2, charges are applied to each of the emission material layers to increase the luminous efficiency and to lower the supply voltage.

The first stack ST1 may be located on the first anode electrode AE1, the second anode electrode AE2 (see, e.g., FIG. 9) and the third anode electrode AE3 (see, e.g., FIG. 9), and may further include the first hole transport layer(HTL1, The first electron block layer BIL1 and the first electron transport layer ETL1.

The first hole transport layer HTL1 may be located on the first anode electrode AE1, the second anode electrode AE2 and the third anode electrode AE3 (see, e.g., FIG. 9). The first hole transport layer HTL1 may facilitate the transport of holes and may include a hole transport material. The hole transport material may include, but is not limited to, carbazole derivatives such as N-phenylcarbazole and polyvinylcarbazole, fluorene derivatives, triphenylamine derivatives such as TPD(N,N'-bis(3-methylphenyl)-N,N'-diphenyl-[1,1-biphenyl]-4,4'-diamine) and TCTA(4,4',4"-tris(N-carbazolyl)triphenylamine), NPB(N,N'-di(1-naphthyl)-N,N'-diphenylbenzidine), TAPC(4,4'-Cyclohexylidene bis[N,N-bis(4-methylphenyl)benzenamine]), etc.

The first electron block layer BIL1 may be located on the first hole transport layer HTL1 and may be located between the first hole transport layer HTL1 and the first emission material layer EML1. The first electron block layer BIL1 may include the hole transport material and a metal or a metal compound to prevent the electrons generated in the first emission material layer EML1 from flowing into the first hole transport layer HTL1. According to some example embodiments, the first hole transport layer HTL1 and the first electron block layer BIL1 described above may be made up of a single layer where the materials are mixed.

The first electron transport layer ETL1 may be located on the first emission material layer EML1, and may be located between the first charge generation layer CGL1 and the first emission material layer EML1. According to some example embodiments, the first electron transport layer ETL1 may include electron transparent material such as Alq3(Tris(8-hydroxyquinolinato)aluminum), TPBi(1,3,5-Tri(1-phenyl-1H-benzo[d]imidazol-2-yl)phenyl), BCP(2,9-Dimethyl-4,7-diphenyl-1,10-phenanthroline), Bphen(4,7-Diphenyl-1,10-phenanthroline), TAZ(3-(4-Biphenylyl)-4-phenyl-5-tert-butylphenyl-1,2,4-triazole), NTAZ(4-(Naphthalen-1-yl)-3,5-diphenyl-4H-1,2,4-triazole), tBu-PBD(2-(4-Biphenylyl)-5-(4-tert-butylphenyl)-1,3,4-oxadiazole), BAlq(Bis(2-methyl-8-quinolinolato-N1,O8)-(1,1'-Biphenyl-4-olato)aluminum), Bebq2(berylliumbis(benzoquinolin-10-olate), ADN(9,10-di(naphthalene-2-yl)anthracene) and a mixture thereof. It is to be noted that the type of the electron transport material is not particularly limited herein. The second stack ST2 may be located on the first charge generation layer CGL1 and may further include a second hole transport layer HTL2, a second electron block layer BIL2 and a second electron transport layer ETL2.

The second hole transport layer HTL2 may be located on the first charge generation layer CGL1. The second hole transport layer HTL2 may be made of the same material as the first hole transport layer HTL1 or may include one or more materials selected from materials listed above as materials included in the first hole transport layer HTL1. The second hole transport layer HTL2 may be made up of a single layer or multiple layers.

The second electron block layer BIL2 may be located on the second hole transport layer HTL2 and may be located between the second hole transport layer HTL2 and the first emission material layer EML2. The second electron block layer BIL2 may be made of the same material and the same structure as the first electron block layer BIL1 or may include one or more materials selected from materials listed above as the materials included in the first electron block layer BIL1.

The second electron transport layer ETL2 may be located on the second emission material layer EML2, and may be located between the second charge generation layer CGL2 and the second emission material layer EML2. The second electron transport layer ETL2 may be made of the same material and the same structure as the first electron transport layer ETL1 or may include one or more materials selected from materials listed above as the materials included in the first electron transport layer ETL1. The second electron transport layer ETL2 may be made up of a single layer or multiple layers.

The second charge generation layer CGL2 may be located on the second stack ST2 and may be located between the second stack ST2 and the third stack ST3.

The second charge generation layer CGL2 may have the same structure as the first charge generation layer CGL1 described above. For example, the second charge generation layer CGL2 may include an n-type charge generation layer CGL21 located closer to the second stack ST2 and a p-type charge generation layer CGL22 located closer to the cathode electrode CE. The p-type charge generation layer CGL22 may be located on the n-type charge generation layer CGL21.

The second charge generation layer CGL2 may have a junction structure between the n-type charge generation layer CGL21 and the p-type charge generation layer CGL22. The first charge general layer CGL1 and the second charge general layer CGL2 may be made of different materials or may be made of the same material.

The second stack ST2 may be located on the second charge generation layer CGL2 and may further include a third hole transport layer HTL3 and a third electron transport layer ETL3.

The third hole transport layer HTL3 may be located on the second charge generation layer CGL2. The third hole transport layer HTL3 may be made of the same material as the first hole transport layer HTL1 or may include one or more materials selected from materials listed above as materials included in the first hole transport layer HTL1. The third hole transport layer HTL3 may be made up of a single layer or multiple layers. When the third hole transport layer HTL3 is made up of multiple layers, the layers may include different materials.

The third electron transport layer ETL3 may be located on the third emission material layer EML3, and may be located between the cathode electrode CE and the third emission material layer EML3. The third electron transport layer ETL3 may be made of the same material and the same structure as the first electron transport layer ETL1 or may include one or more materials selected from materials listed above as the materials included in the first electron transport layer ETL1. The third electron transport layer ETL3 may be made up of a single layer or multiple layers. When the third electron transport layer ETL3 is made up of multiple layers, the layers may include different materials.

According to some example embodiments, a hole injection layer may be further located between the first stack ST1 and the first anode electrode AE1, the second anode electrode AE2 and the third anode electrode AE3 (see, e.g., FIG. 9), between the second stack ST2 and the first charge generation layer CGL1, and/or between the third stack ST3 and the second charge generation layer CGL2. The hole injection layer may facilitate injection of holes into the first emission material layer EML1, the second emission material layer EML2 and the third emission material layer EML3. According to some example embodiments, the hole injection layer may be made of, but is not limited to, at least one selected from the group consisting of: CuPc (copper phthalocyanine), PEDOT (poly(3,4)-ethylenedioxythiophene), PANI (polyaniline) and NPD (N,N-dinaphthyl-N,N'-diphenyl benzidine). According to some example embodiments, the hole injection layer may be located between the first stack ST1 and the first anode electrode AE1, the second anode electrode AE2 and the third anode electrode AE3 (see, e.g., FIG. 9), between the second stack ST2 and the first charge generation layer CGL1, and between the third stack ST3 and the second charge generation layer CGL2.

According to some example embodiments, an electron injection layer may be further located between the third electron transport layer ETL3 and the cathode electrode CE, between the second charge generation layer CGL2 and the second stack ST2, and/or between the first charge generation layer CGL1 and the first stack ST1. The electron injection layer facilitates the injection of electrons and may be made of, but is not limited to, Alq3(tris(8-hydroxyquinolino)aluminum), PBD, TAZ, spiro-PBD, BAlq or SAlq. In addition, the electron injection layer may be a metal halide compound and may be, but is not limited to, at least one selected from the group consisting of: MgF₂, LiF, NaF, KF, RbF, CsF, FrF, Lil, Nal, Kl, Rbl, Csl, Frl and CaF₂. In addition, the electron injection layer may include a lanthanide-based material such as Yb, Sm and Eu. Alternatively, the electron injection layer may include a metal halide material as well as a lanthanide material such as Rbl:Yb and KI:Yb. When the electron injection layer includes both a metal halide material and a lanthanide material, the electron injection layer may be formed by co-deposition of the metal halide material and the lanthanide material. According to some example embodiments, the electron injection layer may be located between the third electron transport layer ETL3 and the cathode electrode CE, between the second charge generation layer CGL2 and the second stack ST2, and between the first charge generation layer CGL1 and the first stack ST1.

In addition to the above-described structure, the structure of the emissive layer OL may be altered. For example, the emissive layer OL may be modified like an emissive layer OLa shown in FIG. 11. Unlike the structure shown in FIG. 10, the emissive layer OLa shown in FIG. 11 may further include a fourth stack ST4 located between the third stack ST3 and the second stack ST2, and may further include a third charge generation layer CGL3 located between the stack ST3 and the second stack ST2.

The fourth stack ST4 may include a fourth emission material layer EML4 and may further include a fourth hole transport layer HTL4, a third electron block layer BIL3, and a fourth electron transport layer ETL4.

The first emission material layer EML1, the second emission material layer EML2, the third emission material layer EML3 and the fourth emission material layer EML4 included in the emissive layer OL may all emit light of the first color, e.g., blue light. At least one of the first emission layer EML1, the second emission layer EML2, or the third emission layer EML3 and/or at least another one of them may emit blue light in different wavelength ranges.

Alternatively, at least one of the first emission layer EML1, the second emission layer EML2, or the third emission layer EML3 may emit green light, while at least another one of them may emit blue light For example, one of the first emission material layer EML1, the second emission material layer EML2, the third emission material layer EML3 and the fourth emission material layer EML4 may be a green emission material layer, while the other three of them may be blue emission material layers.

The fourth hole transport layer HTL4 may be located on the second charge generation layer CGL2. The fourth hole transport layer HTL4 may be made of the same material as the first hole transport layer HTL1 or may include one or more materials selected from materials listed above as materials included in the first hole transport layer HTL1. The fourth hole transport layer HTL4 may be made up of a single layer or multiple layers. When the fourth hole transport layer HTL4 is made up of multiple layers, the layers may include different materials.

The third electron block layer BIL3 may be located on the fourth hole transport layer HTL4 and may be located between the fourth hole transport layer HTL4 and the fourth emission material layer EML4. The third electron block layer BIL3 may be made of the same material and the same structure as the first electron block layer BIL1 or may include one or more materials selected from materials listed above as the materials included in the first electron block layer BIL1. According to some example embodiments, the third electron block layer BIL3 may be eliminated.

The fourth electron transport layer ETL4 may be located on the fourth emission material layer EML4, and may be located between the through charge generation layer CGL3 and the fourth emission material layer EML4. The fourth electron transport layer ETL4 may be made of the same material and the same structure as the first electron transport layer ETL1 or may include one or more materials selected from materials listed above as the materials included in the first electron transport layer ETL1. The fourth electron transport layer ETL4 may be made up of a single layer or multiple layers. When the fourth electron transport layer ETL4 is made up of multiple layers, the layers may include different materials.

The third charge generation layer CGL3 may have the same structure as the first charge generation layer CGL1 described above. For example, the third charge generation layer CGL3 may include an n-type charge generation layer CGL31 located closer to the second stack ST2 and a p-type charge generation layer CGL22 located closer to the cathode electrode CE. The p-type charge generation layer CGL32 may be located on the n-type charge generation layer CGL31.

According to some example embodiments, the electron injection layer may be further located between the fourth stack ST4 and the third charge general layer CGL3. In addition, the hole injection layer may be further located between the fourth stack ST4 and the second charge general layer CGL2.

According to some example embodiments, both the emissive layer OL shown in FIG. 10 and the emissive layer OLa shown in FIG. 11 may not include a red light emissive layer and thus may not emit the light of the first color, e.g., red light. That is to say, the exiting light LE may not include an optical component having a peak wavelength in the range of approximately 610 nm to 650 nm, and the exiting light LE may include only an optical component having a peak wavelength of 440 nm to 550 nm.

The dam member DM may be located more to the outside than the voltage supply line VSL. In other words, as shown in FIG. 12, the voltage supply line VSL may be located between the dam member DM and the display area DA.

According to some example embodiments, a part of the dam member DM may overlap the voltage supply line VSL.

According to some example embodiments, the dam member DM may include a plurality of dams. For example, the dam member DM may include a plurality of dams. For example, the dam member DM may include a first dam D1 and a second dam D2.

The first dam D1 may partially overlap the voltage supply line VSL and may be spaced apart from the third insulating layer 130 with the voltage supply line VSL interposed therebetween. According to some example embodiments, the first dam D1 may include a first lower dam pattern D11 located on the second insulating layer 117 and a first upper dam pattern D12 located on the first lower dam pattern D11.

The second dam D2 may be located on the outer side of the first dam D1 and may be spaced apart from the first dam D1. According to some example embodiments, the second dam D2 may include a second lower dam pattern D21 located on the second insulating layer 117 and a second upper dam pattern D22 located on the second lower dam pattern D21.

According to some example embodiments, the first lower dam pattern D11 and the second lower dam pattern D21 may be made of the same material as the third insulating layer 130 and may be formed together with the third insulating layer 130.

According to some example embodiments, the first upper dam pattern D12 and the second upper dam pattern D22 may be made of the same material as the pixel-defining layer 150 and may be formed together with the pixel-defining layer 150.

According to some example embodiments, the height of the first dam D1 may be different from the height of the second dam D2. For example, the height of the second dam D2 may be larger than the height of the first dam D1. That is to say, the height of the dams included in the dam member DM may gradually increase away from the display area DA. Accordingly, it may be possible to more effectively block an organic matter from overflowing during a process of forming an organic layer 173 included by an encapsulation layer 170, to be described later.

As shown in FIGS. 9, 12 and 13, a first capping layer 160 may be located on the cathode electrode CE. The first capping layer 160 may be located across the first emission area LA1, the second emission area LA2, the third emission area LA3 and the non-emission area NLA, so that viewing angle characteristics can be improved and the out-coupling efficiency can be increased.

The first capping layer 160 may include an inorganic material and/or an organic material having light-transmitting properties. That is to say, the first capping layer 160 may be formed as an inorganic layer, or may be formed as an organic layer, or may be formed as an organic layer containing inorganic particles. For example, the first capping layer 160 may include a triamine derivative, a carbazole biphenyl derivative, an arylene diamine derivative, or an aluminum quinolinolate complex (Alq₃).

In addition, the first capping layer 160 may be made of a mixture of a high-refractive material and a low-refractive material. Alternatively, the first capping layer 160 may include two layers having different refractive indices, for example, a high-refractive layer and a low-refractive layer.

According to some example embodiments, the first capping layer 160 may completely cover the cathode electrode CE. According to some example embodiments, as shown in FIGS. 12 and 13, the end of the first capping layer 160 may be located more to the outside than the end of the cathode electrode CE, and the end of the cathode electrode CE may be completely covered by the first capping layer 160.

The encapsulation layer 170 may be located on the first capping layer 160. The encapsulation layer 170 protects elements located under the encapsulation layer 170 from external foreign substances such as moisture, for example, the light-emitting elements ED1, ED2 and ED3. The encapsulation layer 170 is commonly located across the first emission area LA1, the second emission area LA2, the third emission area LA3, and the non-emission area NLA. According to some example embodiments, the encapsulation layer 170 may directly cover the cathode electrode CE. According to some example embodiments, a capping layer covering the cathode electrode CE may be further located between the encapsulation layer 170 and the cathode electrode CE, in which case the encapsulation layer 170 may directly cover the capping layer. The encapsulation layer 170 may be a thin-film encapsulation layer.

According to some example embodiments, the encapsulation layer 170 may include a lower inorganic layer 171, an organic layer 173 and an upper inorganic layer 175 sequentially stacked on the first capping layer 160.

According to some example embodiments, the lower inorganic layer 171 may cover the first light-emitting diode ED1, the second light-emitting device ED2 and the third light-emitting device ED3 in the display area DA. The lower inorganic layer 171 may cover the dam member DM in the non-display area NDA and may be extended to the outside of the dam member DM.

According to some example embodiments, the lower inorganic layer 171 may completely cover the first capping layer 160. According to some example embodiments, as shown in FIGS. 12 and 13, the end of the lower inorganic layer 171 may be located more to the outside than the end of the first capping layer 160, and the end of the first capping layer 160 may be completely covered by the lower inorganic layer 171.

The organic layer 173 may be arranged or formed over the lower inorganic layer 171. The organic layer 173 may cover the first light-emitting diode ED1, the second light-emitting diode ED2 and the third light-emitting diode ED3 in the display area DA. According to some example embodiments, a part of the organic layer 173 may be located in the non-display area NDA but may not be located outside the dam member DM. Although a part of the organic layer 173 is located more to the inside than the first dam D1 in FIGS. 12 and 13, the present disclosure is not limited thereto. According to some example embodiments, a part of the organic layer 173 may be accommodated in a space between the first dam D1 and the second dam D2, and the end of the organic layer 173 may be located between the first dam D1 and the second dam D2.

The upper inorganic layer 175 may be located on the organic layer 173. The upper inorganic layer 175 may cover the organic layer 173. According to some example embodiments, the upper inorganic layer 175 may be in direct contact with the lower inorganic layer 171 in the non-display area NDA to form an inorganic/inorganic junction. According to some example embodiments, the end of the upper inorganic layer 175 and the end of the lower inorganic layer 171 may be substantially aligned with each other.

Each of the lower inorganic layer 171 and the upper inorganic layer 175 may be made of silicon nitride, aluminum nitride, zirconium nitride, titanium nitride, hafnium nitride, tantalum nitride, silicon oxide, aluminum oxide, titanium oxide, tin oxide, cerium oxide, silicon oxynitride (SiON), lithium fluoride, and the like.

According to some example embodiments, each of the lower inorganic layer 171 and the upper inorganic layer 175 may be made up of, but is not limited to, a single layer. At least one of the lower inorganic layer 171 or the upper inorganic layer 175 may be made up of a structure in which a plurality of layers made of inorganic materials are stacked, for example, a multilayer structure.

According to some example embodiments, the organic layer 173 may be made of acrylic resin, methacrylic resin, polyisoprene, vinyl resin, epoxy resin, urethane resin, cellulose resin and perylene resin.

It is to be noted that the structure of the encapsulation layer 170 is not limited to the above example. The stack structure of the encapsulation layer 170 may be altered in a variety of ways.

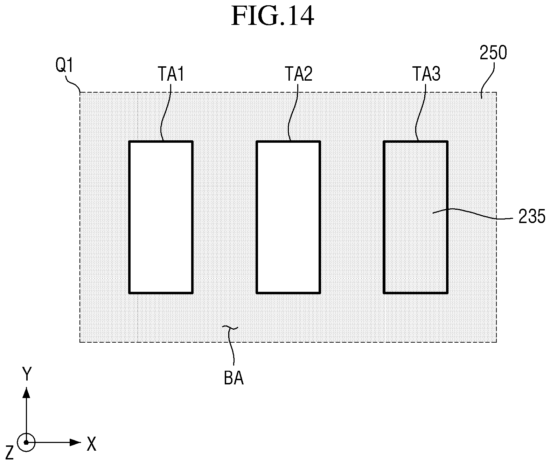

Hereinafter, the color conversion substrate 30 will be described with reference to FIGS. 14 to 18 in conjunction with FIGS. 1 to 13.

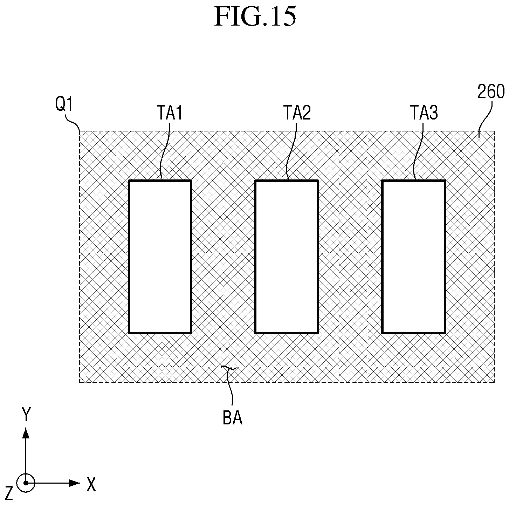

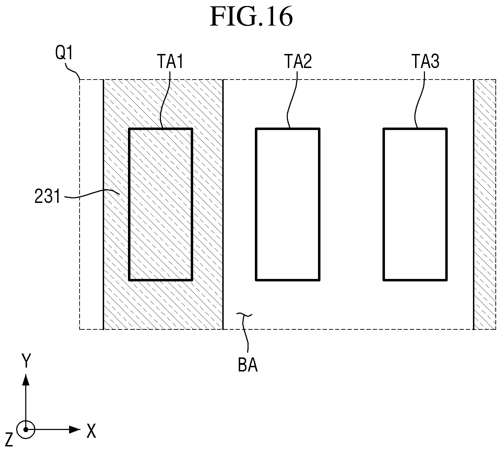

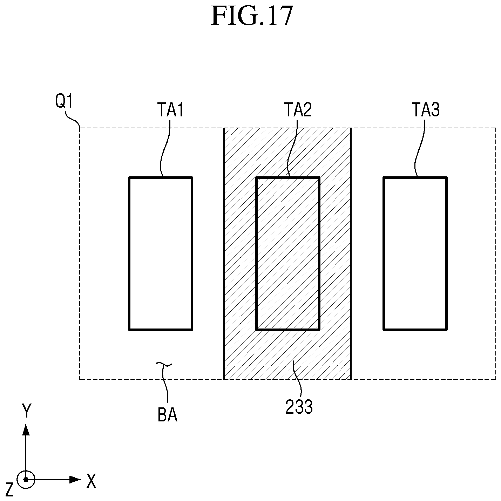

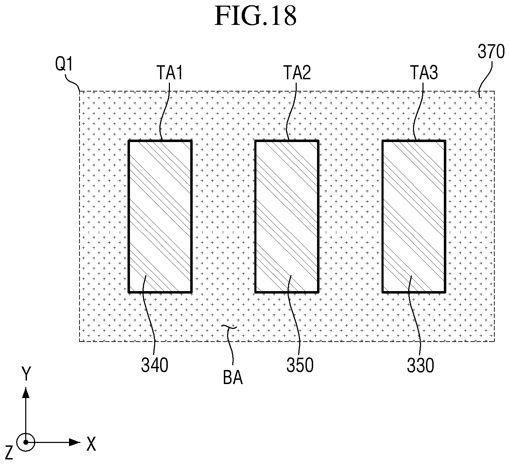

FIG. 14 is a plan view showing a layout of a third color filter and a color pattern on a color conversion substrate of a display device according to some example embodiments of the present disclosure. FIG. 15 is a plan view showing a layout of a light-blocking member on the color conversion substrate of the display device according to some example embodiments of the present disclosure. FIG. 16 is a plan view showing a layout of a first color filter on the color conversion substrate of the display device according to some example embodiments of the present disclosure. FIG. 17 is a plan view showing a layout of a second color filter on the color conversion substrate of the display device according to some example embodiments of the present disclosure. FIG. 18 is a plan view showing layouts of a bank pattern, a first wavelength conversion pattern, a second wavelength conversion pattern and a light-transmitting pattern in the color conversion substrate of the display device according to some example embodiments of the present disclosure.

A second base 310 shown in FIGS. 9, 12 and 13 may be made of a light-transmitting material.

According to some example embodiments, the second base 310 may be a glass substrate or a plastic substrate. According to some example embodiments, the second base 310 may further include a separate layer located on the glass substrate or the plastic substrate, e.g., an insulating layer such as an inorganic film.

According to some example embodiments, a plurality of light-transmitting areas TA1, TA2 and TA3 and a light-blocking area BA may be defined on the second base 310.

As shown in FIGS. 9, 12 and 13, a third color filter 235 and a color pattern 250 may be located on a surface of the second base 310 facing the display substrate 10.

The third color filter 235 may be arranged to overlap the third emission area LA3 or the third light-transmitting area TA3.

The third color filter 235 may selectively transmit the light of the third color (e.g., blue light) while blocking or absorbing the light of the first color (e.g., red light) and the light of the second color (e.g., green light). According to some example embodiments, the third color filter 235 may be a blue color filter and may include a blue colorant such as a blue dye and a blue pigment. As used herein, a colorant encompasses a dye as well as a pigment.

The color pattern 250 may be arranged to overlap the non-emission area NLA and is arranged to overlap the light-blocking area BA. In addition, the color pattern 250 is further located in the non-display area NDA.

The color pattern 250 absorbs a part of external light introduced into the display device 1 from the outside to thereby reduce the reflected light due to the external light. A substantial amount of external light is reflected to cause a problem that the color gamut of the display device 1 is distorted. In contrast, according to some example embodiments of the present disclosure, by arranging the color pattern 250 in the non-emission area NLA and the non-display area NDA, it may be possible to suppress color distortion caused by external light.

According to some example embodiments, the color pattern 250 may include a blue colorant, such as a blue dye or a blue pigment. According to some example embodiments, the color pattern 250 may be made of the same material as the third color filter 235 and may be formed together with it via the process of forming the third color filter 235. When the color pattern 250 includes a blue colorant, the external light or the reflected light having passed through the color pattern 250 may be blue light. The eye color sensibility that a user's eyes perceive varies depending on the color of the light. For example, the light in the blue wavelength band may be perceived less sensitively to a user than the light in the green wavelength band and the light in the red wavelength band. Thus, as the color pattern 250 includes the blue colorant, the user can perceive the reflected light relatively less sensitively.

According to some example embodiments, as shown in FIG. 14, the color pattern 250 may be formed throughout the light-blocking area BA. In addition, according to some example embodiments, as shown in FIG. 14, the color pattern 250 may be connected to the third color filter 235.

As shown in FIGS. 9, 12 and 13, the light-blocking pattern 260 may be located on a surface of the second base 310 facing the display substrate 10. The light-blocking pattern 260 may be arranged to overlap the light-blocking area BA to block transmission of light. According to some example embodiments, the light-blocking pattern 260 may be arranged in a substantially lattice formation when viewed from the top (e.g., when views from a direction normal or perpendicular to a display surface of the display device 1) as shown in FIG. 15.

According to some example embodiments, the light-blocking pattern 260 may include an organic light-blocking material and may be formed via processes of coating and exposing the organic light-blocking material.

As mentioned earlier, the external light may cause the problem that the color gamut of the display device 1 is distorted. In contrast, according to some example embodiments of the present disclosure, by arranging the light-blocking pattern 260 over the second base 310, at least a part of the external light is absorbed by the light-blocking pattern 260. By doing so, it may be possible to reduce color distortion due to the reflection of the external light. According to some example embodiments, the light-blocking pattern 260 can prevent or reduce the color mixture which may occur when light intrudes into adjacent light-transmitting areas, thereby further improving the color gamut.

According to some example embodiments, the light-blocking pattern 260 may be located on the color pattern 250. In other words, the light-blocking pattern 260 may be located on the opposite side of the second base 310 with the color pattern 250 interposed therebetween.

As the color pattern 250 is located between the light-blocking pattern 260 and the second base 310, according to some example embodiments, the light-blocking pattern 260 may not be in contact with the second base 310.

According to some example embodiments, the light-blocking pattern 260 may be eliminated.

As shown in FIG. 9, a first color filter 231 and a second color filter 233 may be located on a surface of the second base 310 facing the display substrate 10.

The first color filter 231 may be arranged to overlap the first emission area LA1 or the first light-transmitting area TA1, and the second color filter 233 may be arranged to overlap the second emission area LA2 or the second light-transmitting area TA2.

According to some example embodiments, the first color filter 231 may block or absorb light of the third color (e.g., blue light). That is to say, the first color filter 231 may work as a blue-light-blocking filter for blocking blue light. According to some example embodiments, the first color filter 231 may selectively transmit the light of the first color (e.g., red light) while blocking or absorbing the light of the third color (e.g., blue light) and the light of the second color (e.g., green light). For example, the first color filter 231 may be a red color filter and may include a red colorant.

The second color filter 233 may block or absorb light of the third color (e.g., blue light). That is to say, the second color filter 233 may also work as a blue-light-blocking filter. According to some example embodiments, the second color filter 233 may selectively transmit the light of the second color (e.g., green light) while blocking or absorbing the light of the third color (e.g., blue light) and the light of the first color (e.g., red light). For example, the second color filter 233 may be a green color filter and may include a green colorant.

As shown in FIGS. 9 and 16, according to some example embodiments, a part of the first color filter 231 may be further located within the light-blocking area BA, and a part of the second color filter 233 may also be located within the light-blocking area BA as shown in FIGS. 9 and 17.

According to some example embodiments, a part of the first color filter 231 may be further located at a portion of the light-blocking area BA between the first light-transmitting area TA1 and the second light-transmitting area TA2 and a portion between the first light-transmitting area TA1 and the third light-transmitting area TA3.

According to some example embodiments, a part of the second color filter 233 may be further located at a portion of the light-blocking area BA between the first light-transmitting area TA1 and the second light-transmitting area TA2 and a portion of between the second light-transmitting area TA2 and the third light-transmitting area TA3.

Although the first color filter 231 and the second color filter 233 do not overlap with each other in the drawing, the first color filter 231 and the second color filter 233 may overlap with each other the light-blocking area BA between the first light-transmitting area TA1 and the second light-transmitting area TA2. The portion of the first color filter 231 and the portion of the second color filter 233 overlapping each other in the light-blocking area BA may work as a light-blocking member that blocks transmission of light.

Alternatively, according to some example embodiments, the first color filter 231 and the second color filter 233 may be located throughout the entire light-blocking area BA, and the first color filter 231 and the second color filters 233 may overlap each other in the entire light-blocking area BA.

According to some example embodiments, the first color filter 231 and the second color filter 233 may overlap the color pattern 250 in the light-blocking area BA. For example, the color pattern 250 may overlap the first color filter 231 and the second color filter 233 in the portion of the light-blocking area BA between the first light-transmitting area TA1 and the second light-transmitting area TA2. In addition, the color pattern 250 may overlap the second color filter 233 in the light-blocking area BA between the second light-transmitting area TA2 and the third light-transmitting area TA3. In addition, the color pattern 250 may overlap the first color filter 231 in the light-blocking area BA between the third light-transmitting area TA3 and the first light-transmitting area TA1.

The portion of the first color filter 231 and the portion of the color pattern 250 overlapping each other in light-blocking area BA, and the portion of the second color filter 233 and the portion of the color pattern 250 overlapping each other in light-blocking area BA may work as light-blocking members. The portion of the first color filter 231 and the portion of the color pattern 250 overlapping each other in light-blocking area BA, and the portion of the second color filter 233 and the portion of the color pattern 250 overlapping each other in light-blocking area BA can absorb at least a part of the external light to reduce distortion of colors due to the reflection of the external light. In addition, it may be possible to prevent or reduce the light exiting to the outside from intruding into adjacent emission areas to cause color mixing, and thus the color gamut of the display device 1 can be further improved.

According to some example embodiments, at least one of the first color filter 231 or the second color filter 233 may be further located in the non-display area NDA. For example, as shown in FIGS. 12 and 13, the first color filter 231 may be further located in the non-display area NDA and may overlap the color pattern 250 in the non-display area NDA. The color pattern 250 and the first color filter 231 overlapping each other may work as a light-blocking member in the non-display area NDA. When the light-blocking pattern 260 is eliminated, the first color filter 231 may be located directly on the color pattern 250 in the non-display area NDA.

As shown in FIGS. 9, 12, and 13, on one surface of the second base 310, the light-blocking pattern 260, the color pattern 250, the first color filter 231, the second color filter 233, and a second capping layer 391 covering the third color filter 235 may be located. According to some example embodiments, the second capping layer 391 may be in direct contact with the first color filter 231, the second color filter 233, and the third color filter 235. In addition, according to some example embodiments, the second capping layer 391 may be in direct contact with the light-blocking pattern 260.

The second capping layer 391 can prevent or reduce instances of the light-blocking pattern 260, the color pattern 250, the first color filter 231, the second color filter 233 and the third color filter 235 being damaged or contaminated by impurities such as moisture and air introduced from the outside. In addition, the second capping layer 391 can prevent or reduce instances of the colorant contained in the first color filter 231, the second color filter 233 and the third color filter 235 diffusing into other elements, e.g., the first wavelength conversion pattern 340, the second wavelength conversion pattern 350, etc. According to some example embodiments, the second capping layer 391 may be made of an inorganic material. For example, the second capping layer 391 may be made of a material including silicon nitride, aluminum nitride, zirconium nitride, titanium nitride, hafnium nitride, tantalum nitride, silicon oxide, aluminum oxide, titanium oxide, tin oxide, cerium oxide, silicon oxynitride, etc.

According to some example embodiments, the second capping layer 391 may cover side surfaces of the color pattern 250, the light-blocking pattern 260, and the first color filter 231 in the non-display area NDA. In addition, according to some example embodiments, the second capping layer 391 may be in direct contact with the second base 310 in the non-display area NDA.

The bank pattern 370 may be arranged on the surface of the second capping layer 391 facing the display substrate 10. According to some example embodiments, the bank pattern 370 may be located directly on the surface of the second capping layer 391 and may be in direct contact with the second capping layer 391.

According to some example embodiments, the bank pattern 370 may be arranged to overlap the non-emission area NLA or the light-blocking area BA. According to some example embodiments, the bank pattern 370 may surround the first light-transmitting area TA1, the second light-transmitting area TA2 and the third light-transmitting area TA3 when viewed from the top as shown in FIG. 18 The bank pattern 370 may define the space where each of the first wavelength conversion pattern 340, the second wavelength conversion pattern 350 and a light-transmitting pattern 330 is formed.

According to some example embodiments, the bank pattern 370 may be implemented as a single pattern which is a single piece as shown in FIG. 18, but the present disclosure is not limited thereto. According to some example embodiments, a part of the bank pattern 370 surrounding the first light-transmitting area TA1, a part of the bank pattern 370 surrounding the second light-transmitting area TA2, and a part of the bank pattern 370 surrounding the third light-transmitting area TA3 may be formed as separate patterns spaced apart from one another.

When the first wavelength conversion pattern 340, the second wavelength conversion pattern 350 and the light-transmitting pattern 330 are formed by ejecting an ink composition using a nozzle or the like, i.e., , by inkjet printing, the bank pattern 370 may work as a guide to stably position the ejected ink composition at desired positions. In other words, the bank pattern 370 may work as a partition wall.

According to some example embodiments, the bank pattern 370 may overlap the pixel-defining layer 150.

As shown in FIGS. 12 and 13, according to some example embodiments, the bank pattern 370 may be further located in the non-display area NDA. The bank pattern 370 may overlap the color pattern 250 and the first color filter 231 in the non-display area NDA.

According to some example embodiments, the bank pattern 370 may include an organic material that is photo-curable. In addition, according to some example embodiments, the bank pattern 370 may include an organic material that is photo-curable and contains a light-blocking material. When the bank pattern 370 has light-blocking properties, it may be possible to prevent or reduce instances of light intruding into adjacent emission areas in the display area DA. For example, the bank pattern 370 can prevent or reduce instances of the exiting light LE emitted from the second light-emitting diode ED2 entering the first wavelength conversion pattern 340 overlapping the first emission area LA1. In addition, the bank pattern 370 can block or suppress external light from intruding into the elements arranged under the bank pattern 370 in the non-emission area NLA and the non-display area NDA.

As shown in FIGS. 9, 12 and 13, the first wavelength conversion pattern 340, the second wavelength conversion pattern 350 and the light-transmitting pattern 330 may be located on the second capping layer 391. According to some example embodiments, the first wavelength conversion pattern 340, the second wavelength conversion pattern 350 and the light-transmitting pattern 330 may be located in the display area DA.

The light-transmitting pattern 330 may overlap the third emission area LA3 or the third light-emitting diode ED3. The light-transmitting pattern 330 may be located in the space defined by the bank pattern 370 in the third light-transmitting area TA3.

According to some example embodiments, the light-transmitting pattern 330 may be formed in an island shape pattern as shown in FIG. 18. Although the light-transmitting pattern 330 does not overlap with the light-blocking area BA in the drawings, this is merely illustrative. According to some example embodiments, a part of the light-transmitting pattern 330 may overlap the light-blocking area BA.

The light-transmitting pattern 330 can transmit incident light. The exiting light LE provided from the light-emitting diode ED3 may be blue light as described above. The exiting light LE, which is blue light, passes through the light-transmitting pattern 330 and the third color filter 235 and exits to the outside of the display device 1. That is to say, third light LO3 emitted from the third emission area LA3 to the outside of the display device 1 may be blue light.

According to some example embodiments, the light-transmitting pattern 330 may further include a first base resin 331 and may further include first scatterers 333 dispersed in the first base resin 331.

The first base resin 331 may be made of a material having a high light transmittance. According to some example embodiments, the first base resin 331 may be made of an organic material. For example, the first base resin 331 may include an organic material such as an epoxy resin, an acrylic resin, a cardo resin, or an imide resin.

The first scatterers 333 may have a refractive index different from that of the first base resin 331 and may form an optical interface with the first base resin 331. For example, the first scatterers 333 may be light scattering particles. The material of the first scatterers 333 is not particularly limited as long as they can scatter at least a part of the transmitted light. For example, the scatterers 450 may be metal oxide particles or organic particles. Examples of the metal oxide may include titanium oxide (TiO₂), zirconium oxide (ZrO₂), aluminum oxide (Al₂O₃), indium oxide (In₂O₃), zinc oxide (ZnO), tin oxide (SnO₂), etc. Examples of the material of the organic particles may include acrylic resins, urethane resins, etc. The first scatterers 333 can scatter light in random directions regardless of the direction in which the incident light is coming, without substantially changing the wavelength of the light transmitted through the light-transmitting pattern 330.

According to some example embodiments, the light-transmitting pattern 330 may be in direct contact with the second capping layer 391 and the bank pattern 370.

The first wavelength conversion pattern 340 may be located on the second capping layer 391 and may overlap the first emission area LA1, the first light-emitting diode ED1 or the first light-transmitting area TA1.

According to some example embodiments, the first wavelength conversion pattern 340 may be located in a space defined by the bank pattern 370 in the first light-transmitting area TA1.

According to some example embodiments, the first wavelength conversion pattern 340 may be formed in an island shape pattern as shown in FIG. 18. Although the first wavelength conversion pattern 340 does not overlap the light-blocking area BA of the first wavelength conversion pattern 340 in the drawings, the present disclosure is not limited thereto. According to some example embodiments, a part of the first wavelength conversion pattern 340 may overlap the light-blocking area BA.

According to some example embodiments, the first wavelength conversion pattern 340 may be in direct contact with the second capping layer 391 and the bank pattern 370.

The first wavelength conversion pattern 340 may convert or shift the peak wavelength of the incident light into light of another peak wavelength. According to some example embodiments, the first wavelength conversion pattern 340 may convert the exiting light LE provided from the first light-emitting diode ED1 into red light having a peak wavelength in the range of 610 to 650 nm.

According to some example embodiments, the first wavelength conversion pattern 340 may include a second base resin 341 and first wavelength shifters 345 dispersed in the second base resin 341, and may further include second scatterers 343 dispersed in the second base resin 341.

The second base resin 341 may be made of a material having a high light transmittance. According to some example embodiments, the second base resin 341 may be made of an organic material. According to some example embodiments, the second base resin 341 may be made of the same material as the first base resin 331, or may include at least one of the materials listed above as the examples of the constituent materials of the first base resin 331.

The first wavelength shifters 345 may convert or shift the peak wavelength of the incident light to another peak wavelength. According to some example embodiments, the first wavelength shifters 345 may convert the exiting light LE of the third color, which is the blue light provided from the first light-emitting diode ED1, into red light having a single peak wavelength in the range of 610 nm to 650 nm.

Examples of the first wavelength shifters 345 may include quantum dots, quantum rods or phosphors. For example, quantum dots may be particulate matter that emits a color as electrons transition from the conduction band to the valence band.

The quantum dots may be semiconductor nanocrystalline material. The quantum dots have a specific band gap depending on their compositions and size, and can absorb light and emit light having an intrinsic wavelength. Examples of the semiconductor nanocrystals of the quantum dots may include Group IV nanocrystals, Groups II - VI compound nanocrystals, Groups III - V compound nanocrystals, Groups IV - VI nanocrystals, or combinations thereof.

The group II - VI compounds may be selected from the group consisting of: binary compounds selected from the group consisting of CdSe, CdTe, ZnS, ZnSe, ZnTe, ZnO, HgS, HgSe, HgTe, MgSe, MgS and a mixture thereof; ternary compounds selected from the group consisting of InZnP, AgInS, CulnS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS and a mixture thereof; and quaternary compounds selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe and a mixture thereof.

The group III - V compounds may be selected from the group consisting of: binary compounds selected from the group consisting of GaN, GaP, GaAs, GaSb, AIN, AlP, AlAs, AlSb, InN, InP, InAs, InSb and a mixture thereof; ternary compounds selected from the group consisting of GaNP, GaNAs, GaNSb, GaPAs, GaPSb, AINP, AlNAs, AlNSb, AlPAs, AlPSb, InGaP, InNP, InAlP, InNAs, InNSb, InPAs, InPSb, GaAlNP and a mixture thereof; and quaternary compounds selected from the group consisting of GaAINAs, GaAINSb, GaAlPAs, GaAlPSb, GalnNP, GalnNAs, GalnNSb, GalnPAs, GalnPSb, InAlNP, InAINAs, InAINSb, InAIPAs, InAIPSb and a mixture thereof.

The group IV - VI compounds may be selected from the group consisting of: binary compounds selected from the group consisting of SnS, SnSe, SnTe, PbS, PbSe, PbTe and a mixture thereof; ternary compounds selected from the group consisting of SnSeS, SnSeTe, SnSTe, PbSeS, PbSeTe, PbSTe, SnPbS, SnPbSe, SnPbTe and a mixture thereof; and quaternary compounds selected from the group consisting of SnPbSSe, SnPbSeTe, SnPbSTe and a mixture thereof. The group IV elements may be selected from the group consisting of Si, Ge and a mixture thereof. The group IV compounds may be binary compounds selected from the group consisting of SiC, SiGe and a mixture thereof.

The binary compounds, the ternary compounds or the quaternary compounds may be present in the particles at a uniform concentration, or may be present in the same particles at partially different concentrations. In addition, they may have a core/shell structure in which one quantum dot surrounds another quantum dot. At the interface between the core and the shell, the gradient of the concentrate of atoms in the shell may decrease toward the center.

According to some example embodiments, the quantum dots may have a core-shell structure including a core comprising the nanocrystals and a shell surrounding the core. The shell of the quantum-dots may serve as a protective layer for maintaining the semiconductor properties by preventing or reducing instances of chemical denaturation of the core and/or as a charging layer for imparting electrophoretic properties to the quantum dots. The shell may be either a single layer or multiple layers. At the interface between the core and the shell, the gradient of the concentrate of atoms in the shell may decrease toward the center. Examples of the shell of the quantum dot may include an oxide of a metal or a non-metal, a semiconductor compound, a combination thereof, etc.

For example, examples of the metal or non-metal oxide may include, but is not limited to, binary compounds such as SiO₂, Al₂O₃, TiO2, ZnO, MnO, Mn₂O₃, Mn₃O₄, CuO, FeO, Fe₂O₃, Fe₃O₄, CoO, Co₃O₄ and NiO or ternary compounds such as MgAl₂O₄, CoFe₂O₄, NiFe₂O₄ and CoMn₂O₄.

Examples of the semiconductor compound may include, but is not limited to, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc.

The light output from the first wavelength shifters 345 may have a full width of half maximum (FWHM) of the emission wavelength spectrum of approximately 45 nm or less, approximately 40 nm or less, or approximately 30 nm or less. In this manner, the color purity and color gamut of the colors displayed by the display device 1 can be further improved. In addition, the light output from the first wavelength shifters 345 may travel in different directions regardless of the incidence direction of the incident light. In this manner, the side visibility of the first color displayed in the first light-transmitting area TA1 can be improved.

A part of the exiting light LE provided from the first light-emitting diode ED1 may not be converted into red light by the first wavelength shifters 345 but may pass through the first wavelength conversion pattern 340. Components of the exiting light LE which are not converted by the first wavelength conversion pattern 340 but are incident on the first color filter 231 may be blocked by the first color filter 231. On the other hand, red light that is converted from the exiting light LE by the first wavelength conversion pattern 340 passes through the first color filter 231 to exit to the outside. That is to say, first light LO1 exiting to the outside of display device 1 through the first light-transmitting area TA1 may be red light.

The second scatterers 343 may have a refractive index different from that of the second base resin 341 and may form an optical interface with the second base resin 341. For example, the second scatterers 343 may be light scattering particles. The second scatterers 343 are substantially identical to the first scatterers 333 described above; and, therefore, the redundant description will be omitted.

The second wavelength conversion pattern 350 may be located in the space defined by the bank pattern 370 in the second light-transmitting area TA2,

According to some example embodiments, the second wavelength conversion pattern 350 may be formed in an island shape pattern as shown in FIG. 18. According to some example embodiments, a part of the second wavelength conversion pattern 350 may overlap the light-blocking area BA, unlike that shown in the drawings.

According to some example embodiments, the second wavelength conversion pattern 350 may be in direct contact with the second capping layer 391 and the bank pattern 370.

The second wavelength conversion pattern 350 may convert or shift the peak wavelength of the incident light into light of another peak wavelength and emit the light. According to some example embodiments, the second wavelength conversion pattern 350 may convert the exiting light LE provided from the second light-emitting diode ED2 into green light in the range of approximately 510 to 550 nm.

According to some example embodiments, the second wavelength conversion pattern 350 may include a third base resin 351 and second wavelength shifters 355 dispersed in the third base resin 351, and may further include third scatterers 353 dispersed in the third base resin 351.

The third base resin 351 may be made of a material having a high light transmittance. According to some example embodiments, the third base resin 351 may be made of an organic material. According to some example embodiments, the third base resin 351 may be made of the same material as the first base resin 331, or may include at least one of the materials listed above as the examples of the constituent materials of the first base resin 331.

The second wavelength shifters 355 may convert or shift the peak wavelength of the incident light to another peak wavelength. According to some example embodiments, the second wavelength shifters 355 may convert blue light having a peak wavelength in the range of 440 to 480 nm into green light having a peak wavelength in the range of 510 to 550 nm.

Examples of the second wavelength shifters 355 may include quantum dots, quantum rods or phosphors. The second wavelength shifters 355 are substantially identical to the first wavelength shifters 345; and, therefore, the redundant description will be omitted.

According to some example embodiments, the first wavelength shifters 345 and the second wavelength shifters 355 may all be made up of quantum dots. In such case, the particle size of the quantum dots forming the second wavelength shifters 355 may be smaller than the particle size of the quantum dots forming the first wavelength shifters 345.

The third scatterers 353 may have a refractive index different from that of the third base resin 351 and may form an optical interface with the third base resin 351. For example, the third scatterers 353 may be light scattering particles. The third scatterers 353 are substantially identical to the second scatterers 343 described above; and, therefore, the redundant description will be omitted.

The exiting light LE emitted from the third light-emitting diode ED2 may be provided to the second wavelength conversion pattern 350. The second wavelength shifters 355 may convert the exiting light LE provided from the third light-emitting diode ED3 into green light having a peak wavelength in the range of approximately 510 to 550 nm.

A part of the exiting light LE, which is blue light, may not be converted into green light by the second wavelength shifters 355 but may pass through the second wavelength conversion pattern 350, which may be blocked by the second color filter 223. On the other hand, green light that is converted from the exiting light LE by the second wavelength conversion pattern 350 passes through the second color filter 233 to exit to the outside. Accordingly, second light LO2 exiting to the outside of the display device 1 from the second light-transmitting area TA2 may be green light.

A third capping layer 393 may be located on the bank pattern 370, the light-transmitting pattern 330, the first wavelength conversion pattern 340 and the second wavelength conversion pattern 350. The third capping layer 393 may cover the light-transmitting pattern 330, the first wavelength conversion pattern 340 and the second wavelength conversion pattern 350. According to some example embodiments, the third capping layer 393 may be located in the non-display area NDA as well. In the non-display area NDA (see, e.g., FIG. 1), the third capping layer 393 may be in direct contact with the second capping layer 391 and can seal the light-transmitting pattern 330, the first wavelength conversion pattern 340 and the second wavelength conversion pattern 350. Thus, it may be possible to prevent or reduce instances of impurities such as moisture and air permeating from the outside to damage or contaminate the light-transmitting pattern 330, the first wavelength conversion pattern 340 and the second wavelength conversion pattern 350.

According to some example embodiments, the third capping layer 393 may cover the outer surfaces of the bank pattern 370 in the non-display area NDA. In addition, the third capping layer 393 may be in direct contact with the second capping layer 391 in the non-display area NDA.

According to some example embodiments, the third capping layer 393 may be made of an inorganic material. According to some example embodiments, the third capping layer 393 may be made of the same material as the second capping layer 391 or may include at least one of those listed above as the materials of the second capping layer 391. When both the second capping layer 391 and the third capping layer 393 are made of an inorganic material, in the non-display area NDA, the second capping layer 391 and the third capping layer 393 may be in direct contact with each other to form an inorganic/inorganic junction.

As described above, in the non-display area NDA, the sealing member 50 may be located between the color conversion substrate 30 and the display substrate 10.

The sealing member 50 may overlap the encapsulation layer 170. For example, the sealing member 50 may overlap the lower inorganic layer 171 and the upper inorganic layer 175 and may not be overlap the organic layer 173. According to some example embodiments, the sealing member 50 may be in direct contact with the encapsulation layer 170. For example, the sealing member 50 may be located directly on the upper inorganic layer 175 and may be in direct contact with the upper inorganic layer 175.

According to some example embodiments, the upper inorganic layer 175 and the lower inorganic layer 171 arranged under the sealing member 50 may be extended to the outside of the sealing member 50.

The sealing member 50 may overlap the color pattern 250, the first color filter 231 and the bank pattern 370 in the non-display area NDA. According to some example embodiments, the sealing member 50 may be in direct contact with the third capping layer 393 covering the bank pattern 370.

The filler 70 may be located in the space defined by the color conversion substrate 30, the display substrate 10 and the sealing member 50, as described above. According to some example embodiments, the filler 70 may be in contact with the third capping layer 393 and the upper inorganic layer 175 of the encapsulation layer 170, as shown in FIGS. 9, 12, and 13.

In the display device 1 according to some example embodiments, the discharge path for the static electricity ESD introduced into the color conversion substrate 30 may be formed between the sealing member 50 and the display area DA. As described above, the discharge passage of the static electricity ESD introduced into the color conversion substrate 30 may be located at the part of the non-display area NDA that is adjacent to at least one of the second to fourth sides L2 to L4 of the display device 1 except for the first side L1, and may be the connection electrode CNE and the voltage supply line VSL electrically separated from the cathode electrode CE.

As the discharge passage of the static electricity ESD introduced into the color conversion substrate 30, by utilizing the connection electrode CNE and the voltage supply line VSL which are located at the part of the non-display area NDA that is adjacent to at least one of the second to fourth sides L2 to L4 of the display device 1 except for the first side L1 and electrically separated from the cathode electrode CE, the area of the non-display area NDA can be increased. As a result, it may be possible to reduce the dead space of the display device 1.

Furthermore, by utilizing the connection electrode CNE arranged on the same layer as the anode electrodes AE1 to AE3 as the discharge path, the resistance from the color conversion substrate 30 to the discharge path is reduced, compared to the guide ring including only the first conductive layer. As a result, it may be possible to greatly reduce the amount of static electricity flowing into the display area DA.

Hereinafter, display devices according to some example embodiments of the present disclosure will be described. In the following description, the same or similar elements will be denoted by the same or similar reference numerals, and redundant descriptions will be omitted or briefly described.

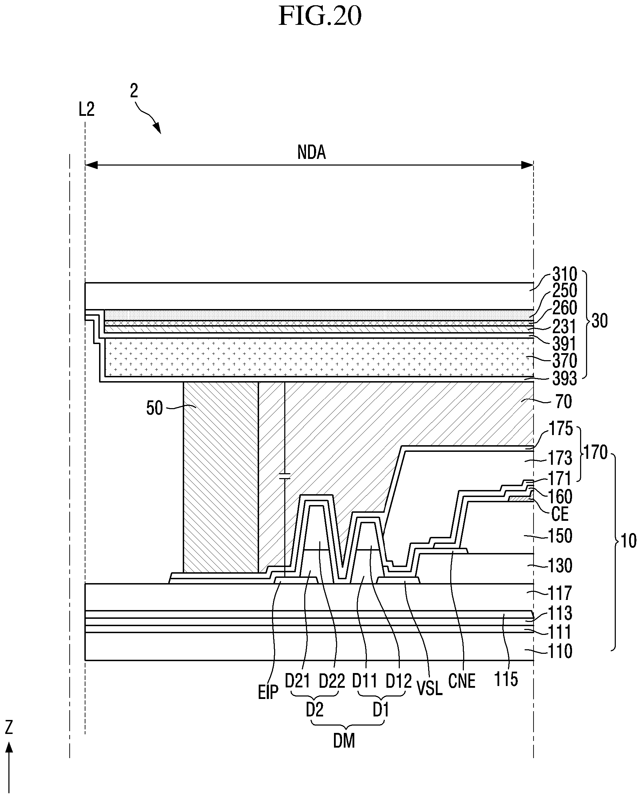

FIG. 20 is a cross-sectional view of a display device according to some example embodiments of the present disclosure.

A display device 2 according to some example embodiments of FIG. 20 is different from the display device 1 shown in FIG. 13 in that a cathode electrode CE may be electrically connected to and in contact with a connection electrode CNE in the non-display area NDA in the parts of the non-display area NDA that are adjacent to the second side L2 to the fourth side L4 of the display device 1 as well as the part of the non-display area NDA that is adjacent to the first side L1 of the display device 1.

For example, in the display device 2 according to some example embodiments, the cathode electrode CE may be electrically connected to and in contact with the connection electrode CNE in the non-display area NDA in the parts of the non-display area NDA that are adjacent to the second side L2 to the fourth side L4 of the display device 1 as well as the part of the non-display area NDA that is adjacent to the first side L1 of the display device 1.

The display device 2 according to some example embodiments may further include a static electricity induction pattern EIP located between the sealing member 50 and the display area DA when viewed from the top. The display substrate 10 may further include the static electricity induction pattern EIP. The static electricity induction pattern EIP may be a first sink pattern.

The static electricity induction pattern EIP may be located on the same layer as the voltage supply line VSL.

The static electricity induction pattern EIP may overlap with the dam member DM in the thickness direction. For example, the static electricity induction pattern EIP may partially overlap the second dam D2 in the thickness direction. When the static electricity induction pattern EIP partially overlap with the second dam D2 in the thickness direction, the static electricity induction pattern EIP may be located directly on the upper surface of the second insulating layer 117, and the second lower dam pattern D21 may be in direct contact with the upper surface and the side surface of the static electricity induction pattern EIP which are closer to the display area DA. Furthermore, the lower inorganic layer 171 and the upper inorganic layer 175 may be arranged to overlap with the remaining part of the upper surface of the static electricity induction pattern EIP. The lower inorganic layer 171 may be in direct contact with the remaining upper surface and the side surface of the static electricity induction pattern EIP.

The static electricity induction pattern EIP may work as a discharge path of static electricity introduced into the color conversion substrate 30.

According to some example embodiments, the electrostatic induction pattern EIP is further arranged between the sealing member 50 and the display area DA when viewed from the top, so that the area of the non-display area NDA can be increased, thereby reducing the dead space in the display area DA of the display device 1.

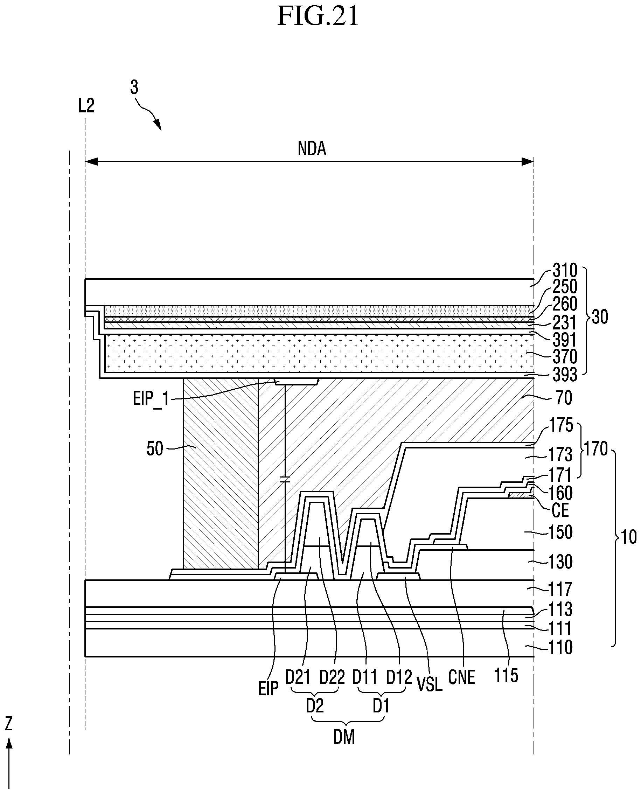

FIG. 21 is a cross-sectional view of a display device according to some example embodiments of the present disclosure.

A color conversion substrate 30 of a display device 3 according to some example embodiments shown in FIG. 21 is different from the display device 2 of FIG. 20 in that the former further includes a static electricity induction pattern EIP_1 arranged between a third capping layer 393 and a filler 70.

For example, the color conversion substrate 30 of the display device 3 according to some example embodiments further includes the static electricity induction pattern EIP_1 arranged between the third capping layer 393 and the filler 70. The static electricity induction pattern EIP_1 may be a second sink pattern. The static electricity induction pattern EIP may be a first sink pattern.

The static electricity induction pattern EIP_1 may overlap the static electricity induction pattern EIP of the display substrate 10 in the thickness direction.

The static electricity introduced into the color conversion substrate 30 may be guided (or induced) into the static electricity induction pattern EIP_1. The static electricity induced into the static electricity induction pattern EIP_1 of the color conversion substrate 30 may be induced (or guided) into the static electricity induction pattern EIP of the display substrate 10 which overlaps it in the thickness direction. In this way, the static electricity can be discharged to the outside.

According to some example embodiments, the electrostatic induction pattern EIP_1 is further arranged between the sealing member 50 and the display area DA when viewed from the top, so that the area of the non-display area NDA can be increased, thereby reducing the dead space in the display area DA of the display device 1.

Although embodiments of the invention have been disclosed for illustrative purposes, those skilled in the art will appreciate that various modifications, additions and substitutions are possible, without departing from the scope of the invention as defined by the accompanying claims.

## Claims

1. A display device (1) comprising:
a first base (110) on which a display area (DA) and a non-display area (NDA) are defined;
a light-emitting element (ED1, ED2, ED3) on the first base and in the display area;
a second base (310) facing the first base and above the light-emitting element;
a color conversion substrate (30), the color conversion substrate comprising:
a color filter (231, 233, 235) on a surface of the second base that faces the first base and overlapping the light-emitting element; and
a wavelength conversion pattern (340, 350) on the color filter;
wherein a plurality of light-transmitting areas (TA1, TA2, TA3) and a light-blocking area (BA) are defined in the color conversion substrate in the display area;
wherein the display device further comprises a color pattern (250) located in the non-display area and overlapping the light-blocking area, the color pattern configured to absorb a part of external light introduced into the display device from the outside; and
wherein the display device further comprises a sealing member (50) in the non-display area between the first base and the second base;
the display device **characterized by** the color filter overlapping the color pattern in the non-display area; and by the display device further comprising a sink pattern (EIP, EIP_1) in the non-display area,
wherein the sink pattern is between the sealing member and the display area when viewed from a plan view; wherein the sink pattern is electrically separated from the light-emitting element; and wherein the sink pattern is a discharge path of static electricity introduced into the color conversion substrate.

2. The display device of claim 1, wherein the light-emitting element comprises:
an anode electrode (AE1, AE2) on the second base;
a cathode electrode (CE) facing the anode electrode; and
an emissive layer (OL) between the anode electrode and the cathode electrode,
wherein the sink pattern is electrically separated from the cathode electrode.

3. The display device of any preceding claim, further comprising:
a first conductive layer between the first base and the light-emitting element,
wherein the sink pattern is on the first conductive layer.

4. The display device of any preceding claim, wherein the sink pattern comprises a voltage supply line (VSL), and
wherein the voltage supply line is electrically connected to a supply pad in the non-display area.

5. The display device of claim 3 when dependent upon claim 2, further comprising:
a first insulating layer (130) between the first conductive layer and the anode electrode, and a pixel-defining layer (150) on the anode electrode to partially expose the anode electrode,
wherein the first insulating layer exposes a part of an upper surface of the sink pattern.

6. The display device of claim 5, wherein an end of the cathode electrode is located on an inner side of an end of the pixel-defining layer.

7. The display device of claim 2 or any claim dependent thereon, further comprising:
a connection pattern connected to the sink pattern,
wherein the connection pattern is on a same layer as the anode electrode and is in direct contact with the sink pattern, and
wherein the connection pattern is separated from the anode electrode.

8. The display device of any preceding claim, further comprising:
an encapsulation layer (170) over the light-emitting element, wherein the encapsulation layer comprises a lower inorganic layer (171) on the light-emitting element, an organic layer (173) on the lower inorganic layer, and an upper inorganic layer (175) on the organic layer,
wherein the sealing member is on the upper inorganic layer in the non-display area, and
wherein the sealing member overlaps the lower inorganic layer and the upper inorganic layer

9. The display device of claim 8, wherein the sealing member is in direct contact with the upper inorganic layer.

10. The display device of claim 8 or claim 9, further comprising:
a dam member (DM) on the first base and between the sealing member and the display area,
wherein the dam member surrounds the display area, and
wherein the lower inorganic layer and the upper inorganic layer covers the dam member.

11. The display device of claim 10, wherein the sink pattern comprises a first sink pattern (EIP) overlapping the dam member in a thickness direction.

12. The display device of claim 10 or claim 11, wherein the first sink pattern is between the first base and the light-emitting element.

13. The display device of claim 12 when dependent upon claim 11, wherein the sink pattern further comprises a second sink pattern (EIP_1) on a surface of the second base that faces the first base, and
wherein the second sink pattern overlaps the first sink pattern in the thickness direction.

14. The display device of any preceding claim, further comprising:
a first capping layer (160) between the color filter and the wavelength conversion pattern; and
a second capping layer (391) on the wavelength conversion pattern,
wherein the first capping layer and the second capping layer are in contact with each other in the non-display area, and
wherein the sealing member is in contact with the second capping layer.

15. The display device of claim 14, further comprising:
an encapsulation layer (170) on the light-emitting element; and
a filler located (70) between the second capping layer and the encapsulation layer,
wherein the filler is in contact with the second capping layer, the encapsulation layer, and the sealing member.

## Patentansprüche

1. Anzeigevorrichtung (1), die Folgendes umfasst:
eine erste Basis (110), auf der ein Anzeigebereich (DA) und ein Nichtanzeigebereich (NDA) definiert sind;
ein lichtemittierendes Element (ED1, ED2, ED3) auf der ersten Basis und in dem Anzeigebereich;
eine zweite Basis (310), die der ersten Basis zugewandt ist und sich über dem lichtemittierenden Element befindet;
ein Farbumwandlungssubstrat (30), wobei das Farbumwandlungssubstrat Folgendes umfasst:
einen Farbfilter (231, 233, 235) auf einer Oberfläche der zweiten Basis, die der ersten Basis zugewandt ist und das lichtemittierende Element überlappt; und
ein Wellenlängenumwandlungsmuster (340, 350) auf dem Farbfilter;
wobei eine Vielzahl von lichtdurchlässigen Bereichen (TA1, TA2, TA3) und ein lichtundurchlässiger Bereich (BA) in dem Farbumwandlungssubstrat im Anzeigebereich definiert sind;
wobei die Anzeigevorrichtung ferner ein Farbmuster (250) umfasst, das sich in dem Nichtanzeigebereich befindet und den lichtundurchlässigen Bereich überlappt, wobei das Farbmuster so konfiguriert ist, dass es einen Teil eines von außen in die Anzeigevorrichtung eingeführten externen Lichts absorbiert; und
wobei die Anzeigevorrichtung ferner ein Dichtungselement (50) im Nichtanzeigebereich zwischen der ersten Basis und der zweiten Basis umfasst;
wobei die Anzeigevorrichtung **dadurch gekennzeichnet ist, dass** der Farbfilter das Farbmuster im Nichtanzeigebereich überlappt; und dadurch, dass die Anzeigevorrichtung ferner ein Senkenmuster (EIP, EIP_1) im Nichtanzeigebereich umfasst,
wobei sich das Senkenmuster bei Betrachtung aus der Draufsicht zwischen dem Dichtungselement und dem Anzeigebereich befindet; wobei das Senkenmuster elektrisch vom lichtemittierenden Element getrennt ist; und wobei das Senkenmuster ein Entladungsweg für in das Farbumwandlungssubstrat eingeführte statische Elektrizität ist.

2. Anzeigevorrichtung nach Anspruch 1, wobei das lichtemittierende Element Folgendes umfasst:
eine Anodenelektrode (AE1, AE2) auf der zweiten Basis;
eine Kathodenelektrode (CE), die der Anodenelektrode zugewandt ist; und
eine Emissionsschicht (OL) zwischen der Anodenelektrode und der Kathodenelektrode,
wobei das Senkenmuster von der Kathodenelektrode elektrisch getrennt ist.

3. Anzeigevorrichtung nach einem vorhergehenden Anspruch, die ferner Folgendes umfasst:
eine erste leitfähige Schicht zwischen der ersten Basis und dem lichtemittierenden Element,
wobei sich das Senkenmuster auf der ersten leitfähigen Schicht befindet.

4. Anzeigevorrichtung nach einem vorhergehenden Anspruch, wobei das Senkenmuster eine Spannungsversorgungsleitung (VSL) umfasst, und
wobei die Spannungsversorgungsleitung elektrisch mit einem Versorgungspad im Nichtanzeigebereich verbunden ist.

5. Anzeigevorrichtung nach Anspruch 3, wenn abhängig von Anspruch 2, die ferner Folgendes umfasst:
eine erste Isolierschicht (130) zwischen der ersten leitfähigen Schicht und der Anodenelektrode, und eine pixeldefinierende Schicht (150) auf der Anodenelektrode, um die Anodenelektrode teilweise freizulegen,
wobei die erste Isolierschicht einen Teil einer Oberseite des Senkenmusters freilegt.

6. Anzeigevorrichtung nach Anspruch 5, wobei ein Ende der Kathodenelektrode auf einer Innenseite eines Endes der pixeldefinierenden Schicht liegt.

7. Anzeigevorrichtung nach Anspruch 2 oder einem davon abhängigen Anspruch, die ferner Folgendes umfasst:
ein mit dem Senkenmuster verbundenes Verbindungsmuster,
wobei sich das Verbindungsmuster auf derselben Schicht wie die Anodenelektrode befindet und in direktem Kontakt mit dem Senkenmuster steht, und
wobei das Verbindungsmuster von der Anodenelektrode getrennt ist.

8. Anzeigevorrichtung nach einem vorhergehenden Anspruch, die ferner Folgendes umfasst:
eine Verkapselungsschicht (170) über dem lichtemittierenden Element, wobei die Verkapselungsschicht eine untere anorganische Schicht (171) auf dem lichtemittierenden Element, eine organische Schicht (173) auf der unteren anorganischen Schicht und eine obere anorganische Schicht (175) auf der organischen Schicht umfasst,
wobei sich das Dichtungselement auf der oberen anorganischen Schicht im Nichtanzeigebereich befindet, und
wobei das Dichtungselement die untere anorganische Schicht und die obere anorganische Schicht überlappt.

9. Anzeigevorrichtung nach Anspruch 8, wobei das Dichtungselement in direktem Kontakt mit der oberen anorganischen Schicht steht.

10. Anzeigevorrichtung nach Anspruch 8 oder Anspruch 9, die ferner Folgendes umfasst:
ein Dammelement (DM) auf der ersten Basis und zwischen dem Dichtungselement und dem Anzeigebereich,
wobei das Dammelement den Anzeigebereich umgibt, und
wobei die untere anorganische Schicht und die obere anorganische Schicht das Dammelement bedecken.

11. Anzeigevorrichtung nach Anspruch 10, wobei das Senkenmuster ein erstes Senkenmuster (EIP) umfasst, das das Dammelement in einer Dickenrichtung überlappt.

12. Anzeigevorrichtung nach Anspruch 10 oder Anspruch 11, wobei sich das erste Senkenmuster zwischen der ersten Basis und dem lichtemittierenden Element befindet.

13. Anzeigevorrichtung nach Anspruch 12, wenn abhängig von Anspruch 11, wobei das Senkenmuster ferner ein zweites Senkenmuster (EIP_1) auf einer Oberfläche der zweiten Basis umfasst, die der ersten Basis zugewandt ist, und
wobei das zweite Senkenmuster das erste Senkenmuster in der Dickenrichtung überlappt.

14. Anzeigevorrichtung nach einem vorhergehenden Anspruch, das ferner Folgendes umfasst:
eine erste Deckschicht (160) zwischen dem Farbfilter und dem Wellenlängenumwandlungsmuster; und
eine zweite Deckschicht (391) auf dem Wellenlängenumwandlungsmuster,
wobei die erste Deckschicht und die zweite Deckschicht in dem Nichtanzeigebereich miteinander in Kontakt stehen, und
wobei das Dichtungselement mit der zweiten Deckschicht in Kontakt steht.

15. Anzeigevorrichtung nach Anspruch 14, die ferner Folgendes umfasst:
eine Verkapselungsschicht (170) auf dem lichtemittierenden Element; und
einen Füllstoff (70), der sich zwischen der zweiten Deckschicht und der Verkapselungsschicht befindet,
wobei der Füllstoff mit der zweiten Deckschicht, der Verkapselungsschicht und dem Dichtungselement in Kontakt steht.

## Revendications

1. Dispositif d'affichage (1) comprenant :
une première base (110) sur laquelle une zone d'affichage (DA) et une zone de non-affichage (NDA) sont définies,
un élément électroluminescent (ED1, ED2, ED3) sur la première base et dans la zone d'affichage,
une deuxième base (310) faisant face à la première base et au-dessus de l'élément électroluminescent,
un substrat de conversion de couleur (30), le substrat de conversion de couleur comprenant :
un filtre de couleur (231, 233, 235) sur une surface de la deuxième base qui fait face à la première base et chevauche l'élément électroluminescent, et
un motif de conversion de longueur d'onde (340, 350) sur le filtre de couleur,
dans lequel une pluralité de zones transmettant la lumière (TA1, TA2, TA3) et une zone bloquant la lumière (BA) sont définies dans le substrat de conversion de couleur dans la zone d'affichage,
dans lequel le dispositif d'affichage comprend en outre un motif de couleur (250) situé dans la zone de non-affichage et chevauchant la zone bloquant la lumière, le motif de couleur étant configuré pour absorber une partie d'une lumière extérieure introduite dans le dispositif d'affichage à partir de l'extérieur, et
dans lequel le dispositif d'affichage comprend en outre un élément d'étanchéité (50) dans la zone de non-affichage entre la première base et la deuxième base,
le dispositif d'affichage étant **caractérisé en ce que** le filtre de couleur chevauche le motif de couleur dans la zone de non-affichage ; et **en ce que** le dispositif d'affichage comprend en outre un motif de dissipateur (EIP, EIP_1) dans la zone de non-affichage,
dans lequel le motif de dissipateur est entre l'élément d'étanchéité et la zone d'affichage dans une vue en plan ;dans lequel le motif de dissipateur est séparé électriquement de l'élément électroluminescent ; et dans lequel le motif de dissipateur est un trajet de décharge d'électricité statique introduite dans le substrat de conversion de couleur.

2. Dispositif d'affichage selon la revendication 1, dans lequel l'élément électroluminescent comprend :
une électrode d'anode (AE1, AE2) sur la deuxième base,
une électrode de cathode (CE) faisant face à l'électrode d'anode, et
une couche émettrice (OL) entre l'électrode d'anode et l'électrode de cathode,
dans lequel le motif de dissipateur est séparé électriquement de l'électrode de cathode.

3. Dispositif d'affichage selon l'une quelconque des revendications précédentes, comprenant en outre :
une première couche conductrice entre la première base et l'élément électroluminescent,
dans lequel le motif de dissipateur est sur la première couche conductrice.

4. Dispositif d'affichage selon l'une quelconque des revendications précédentes, dans lequel le motif de dissipateur comprend une ligne d'alimentation en tension (VSL), et
dans lequel la ligne d'alimentation en tension est connectée électriquement à un plot d'alimentation dans la zone de non-affichage.

5. Dispositif d'affichage selon la revendication 3 lorsqu'elle dépend de la revendication 2, comprenant en outre :
une première couche isolante (130) entre la première couche conductrice et l'électrode d'anode, et une couche définissant des pixels (150) sur l'électrode d'anode pour exposer en partie l'électrode d'anode,
dans lequel la première couche isolante expose une partie d'une surface supérieure du motif de dissipateur.

6. Dispositif d'affichage selon la revendication 5, dans lequel une extrémité de l'électrode de cathode est située sur un côté intérieur d'une extrémité de la couche définissant des pixels.

7. Dispositif d'affichage selon la revendication 2 ou une quelconque revendication dépendant de celle-ci, comprenant en outre :
un motif de connexion connecté au motif de dissipateur,
dans lequel le motif de connexion est sur une même couche que l'électrode d'anode et est en contact direct avec le motif de dissipateur, et
dans lequel le motif de connexion est séparé de l'électrode d'anode.

8. Dispositif d'affichage selon l'une quelconque des revendications précédentes, comprenant en outre :
une couche d'encapsulation (170) au-dessus de l'élément électroluminescent, dans lequel la couche d'encapsulation comprend une couche inorganique inférieure (171) sur l'élément électroluminescent, une couche organique (173) sur la couche inorganique inférieure, et une couche inorganique supérieure (175) sur la couche organique,
dans lequel l'élément d'étanchéité est sur la couche inorganique supérieure dans la zone de non-affichage, et
dans lequel l'élément d'étanchéité chevauche la couche inorganique inférieure et la couche inorganique supérieure.

9. Dispositif d'affichage selon la revendication 8, dans lequel l'élément d'étanchéité est en contact direct avec la couche inorganique supérieure.

10. Dispositif d'affichage selon la revendication 8 ou la revendication 9, comprenant en outre :
un élément de barrage (DM) sur la première base et entre l'élément d'étanchéité et la zone d'affichage,
dans lequel l'élément de barrage entoure la zone d'affichage, et
dans lequel la couche inorganique inférieure et la couche inorganique supérieure recouvrent l'élément de barrage.

11. Dispositif d'affichage selon la revendication 10, dans lequel le motif de dissipateur comprend un premier motif de dissipateur (EIP) chevauchant l'élément de barrage dans une direction d'épaisseur.

12. Dispositif d'affichage selon la revendication 10 ou la revendication 11, dans lequel le premier motif de dissipateur est entre la première base et l'élément électroluminescent.

13. Dispositif d'affichage selon la revendication 12 lorsqu'elle dépend de la revendication 11, dans lequel le motif de dissipateur comprend en outre un deuxième motif de dissipateur (EIP_1) sur une surface de la deuxième base qui fait face à la première base, et
dans lequel le deuxième motif de dissipateur chevauche le premier motif de dissipateur dans la direction d'épaisseur.

14. Dispositif d'affichage selon l'une quelconque des revendications précédentes, comprenant en outre :
une première couche de recouvrement (160) entre le filtre de couleur et le motif de conversion de longueur d'onde, et
une deuxième couche de recouvrement (391) sur le motif de conversion de longueur d'onde,
dans lequel la première couche de recouvrement et la deuxième couche de recouvrement sont en contact l'une avec l'autre dans la zone de non-affichage, et
dans lequel l'élément d'étanchéité est en contact avec la deuxième couche de recouvrement.

15. Dispositif d'affichage selon la revendication 14, comprenant en outre :
une couche d'encapsulation (170) sur l'élément électroluminescent, et
une charge (70) située entre la deuxième couche de recouvrement et la couche d'encapsulation,
dans lequel la charge est en contact avec la deuxième couche de recouvrement, la couche d'encapsulation et l'élément d'étanchéité.
